# EUROPEAN PATENT APPLICATION

(11) **EP 4 477 448 A1**
(43) Date of publication of application: **18.12.2024**
(21) Application number: 24175678.2
(22) Date of filing: 14.05.2024
(51) Int. Cl.: B60L 3/00, H01M 10/42

(54) **BATTERY THERMAL EVENT DETECTION SYSTEM**

(30) Priority: 12.06.2023 US 202318333029
(71) Applicant: Volvo Car Corporation, 405 31 Göteborg (SE)
(72) Inventor: CÉSAR, Rui, 40531 Göteborg (SE)
(74) Representative: Maiwald GmbH

(57) **Abstract**

Various systems and methods are presented regarding determining whether a battery onboard a vehicle is undergoing failure/failed. Rather than monitoring all variables/parameters associated with battery, the operating pressure of the battery can be monitored by a pressure component to determine whether a change in pressure within the battery is a function of off-gassing or results from battery failure. By limiting monitoring of the battery to pressure only, when the vehicle is parked/powered down, the ECU that typically monitors a range of parameters can also be powered down (e.g., to reduce power draw from the battery). If a pressure event is identified by the power component, the ECU can be powered up to perform more extensive analysis of the battery to determine whether the battery is failing. In response to a determination that the battery is failing, the vehicle can be autonomously relocated, building evacuated, emergency services contacted, and suchlike.

## Description

### TECHNICAL FIELD

This application relates to monitoring a battery to identify a failure condition of the battery prior to the battery undergoing catastrophic failure.

### BACKGROUND

The benefits of lithium-ion (Li-ion) batteries have rendered them ubiquitous across the globe, from single cells powering portable devices such as smartwatches, cellphones, cameras, etc., through to multi-cell battery packs configured to power vehicles. While sales of battery-powered electric vehicles (EVs) continue to increase, public approval is still somewhat hampered by the limited range of EVs compared to fossil fuel-powered vehicles.

Further, owing to Li-ion battery chemistry, off-gassing as a result of electrolyte decomposition in the battery chemistry can occur at any time during the useable lifetime of the battery, e.g., when the battery is powering the EV, when the EV is parked in a garage overnight, when the battery is being charged, and suchlike. Off-gassing can give rise to physical deformation/structural breakdown of a battery, and can further act as a precursor to an uncontrolled exothermic reaction, aka "thermal runaway". If not rapidly addressed/isolated, thermal runaway can lead to catastrophic failure of the battery, accompanied by potential loss of life and property.

Accordingly, for the continued adoption and implementation, it is beneficial to limit unnecessary power draws of the Li-ion battery and further detect battery failure as soon as possible, ideally before thermal runaway occurs.

The above-described background is merely intended to provide a contextual overview of some current issues and is not intended to be exhaustive. Other contextual information may become further apparent upon review of the following detailed description.

### SUMMARY

The following presents a summary to provide a basic understanding of one or more embodiments described herein. This summary is not intended to identify key or critical elements, or delineate any scope of the different embodiments and/or any scope of the claims. The sole purpose of the summary is to present some concepts in a simplified form as a prelude to the more detailed description presented herein.

In one or more embodiments described herein, systems, devices, computer-implemented methods, methods, apparatus and/or computer program products are presented to ascertain whether a battery pack is failing. In an embodiment, the battery pack can be located on a vehicle.

According to one or more embodiments, a system can be located on a vehicle, The system can comprise a memory that stores computer executable components and a processor that executes the computer executable components stored in the memory. The computer executable components can comprise a sensor component configured to monitor an operating pressure of a battery located on the vehicle, wherein the vehicle is in a powered off mode of operation and high voltage battery module (HVBM) is powered down. The sensor component can be further configured to detect occurrence of an event at the battery and in response to detection of the event at the battery, reinitiate operation of a high voltage battery module (HVBM). In an embodiment, the sensor component is a pressure component configured to determine pressure, and the event is a change in pressure at the battery.

In another embodiment, the sensor component can be further configured to determine a difference between a current pressure value measured at the battery measured by a pressure sensor and a baseline pressure value previously measured by the pressure sensor and in response to the difference being greater than a threshold, identify the event has occurred.

In an embodiment, the HVBM can be configured to analyze signals from one or more systems onboard the vehicle to identify a source of signal interference generated at the one or more systems, wherein the signal interference causing the difference between the current pressure value measured by the pressure sensor and the baseline pressure value measured by the pressure sensor. In an embodiment, the one or more systems can include a motor system, a climate control system, a velocity system, a navigation system, and suchlike.

In another embodiment, the HVBM can be further configured to: (i) identify a first number of sensor signals present in the first set of measurements, (ii) identify a second number of sensor signals present in the second set of measurements, (iii) determine whether the first number of sensor signals equals the second number of sensor signals, and (iv) in response to a determination of the first number of sensor signals does not equal the second number of sensor signals, identify a failed sensor.

In a further embodiment, the HVBM can be further configured to, prior to being powered down, capture a first set of measurements regarding operating condition of the battery at the time the HVBM was powered down. Further, upon operation of the HVBM being reinitiated by the sensor component, the HVBM can capture a second set of measurements regarding a current operating condition of the battery, compare the first set of measurements with the second set of measurements, and furthermore, in response to a discrepancy between the first set of measurements with the second set of measurements, generate and transmit a failure notification that the battery is in a condition of potential failure.

In an embodiment, the battery can be a lithium-ion battery, and the HVBM can be further configured to determine, based on the comparison between the first set of measurements and the second set of measurements, whether the event was an off-gassing event at the battery.

In an embodiment, the computer executable components can further comprise a warning component. The warning component can be configured to receive the failure notification, generate a warning notification indicating the battery is in a potential failure condition, and further transmit the warning notification to a remotely located user device, wherein the warning notification includes an instruction to evacuate a building in which the vehicle is located. In an embodiment, the warning component can be further configured to transmit the warning notification to a navigation component onboard the vehicle, wherein the warning notification includes an instruction for the navigation component to autonomously drive the vehicle to a designated safe location.

In other embodiments, elements described in connection with the disclosed systems can be embodied in different forms such as computer-implemented methods, computer program products, or other forms. For example, in an embodiment, a computer-implemented method can be performed by a device operatively coupled to a processor, wherein the device can be located on a vehicle. In an embodiment, the method can comprise monitoring, by the device, a current pressure condition at a battery pack, wherein the current pressure condition is monitored while a high voltage battery module (HVBM) is powered down, wherein the HVBM is configured to control operation of the battery pack. The method can further comprise comparing, by the device, the current pressure condition with a baseline condition to identify existence of a pressure event at the battery pack, and in response to identifying the existence of the pressure event, activating, by the device, operation of the HVBM configured to determine whether the pressure event is indicative of the battery pack is failing.

In another embodiment, the method can further comprise: (i) during power down of the HVBM, obtaining by the HVBM, a set of operating conditions of the battery pack; (ii) during activation of the HVBM, obtaining by the HVBM, a set of current operating conditions of the battery pack; (iii) comparing, by the HVBM, the set of current operating conditions with the set of power down operating conditions; (iv) determining, by the HVBM, a variation in the current operating conditions versus the power down operating conditions; and (iv) in the event of the variation is indicative of the current condition of the battery pack is failing, generating an alarm indicating the battery pack is failing.

In an embodiment, the battery pack can comprise at least one lithium-ion battery cell. Further, the pressure event is due to off-gassing at the battery pack. Furthermore, the pressure event can be due to at least one of physical failure or chemical failure of at least one cell in the battery pack.

Further embodiments can include a computer program product comprising a computer readable storage medium having program instructions embodied therewith, to determine failure of a battery pack located on a vehicle. The program instructions are executable by a processor, and can cause the processor to monitor a current pressure condition at a battery pack, wherein the current pressure condition is monitored while a HVBM is powered down, wherein the HVBM is configured to control operation of the battery pack, compare the current pressure condition with a baseline pressure condition to identify existence of a pressure event at the battery pack and, further, in response to identifying the existence of the pressure event, activating operation of the HVBM configured to determine whether the pressure event is indicative of the battery pack is failing.

In another embodiment, the program instructions are further executable by the processor to (i) during power down of the HVBM, obtain a set of operating conditions of the battery pack; (ii) during activation of the HVBM, obtain a set of current operating conditions of the battery pack; (iii) compare the set of current operating conditions with the set of power down operating conditions; (iv) determine a variation in the current operating conditions versus the power down operating conditions; and (v) in the event of the variation is indicative of the current condition of the battery pack is failing, generate an alarm indicating the battery pack is failing.

An advantage of the one or more systems, computer-implemented methods, and/or computer program products can be utilizing various systems and technologies to expeditiously determine whether a pressure event at a battery is due to off-gassing or is an indication of a battery is undergoing operational/structural failure. As a function of the HVBM, upon waking, comparing the current operating condition of the battery with a prior condition of the battery, a determination of the battery operating condition can be rapidly assessed, which can be critical in preventing loss of life, property, or injury.

### DESCRIPTION OF THE DRAWINGS

One or more embodiments are described below in the Detailed Description section with reference to the following drawings.
FIG. 1A illustrates a system comprising various components and devices configured to monitor an operating condition of a battery, and based thereon, determine whether the battery may be undergoing physical/chemical failure, in accordance with at least one embodiment.
FIG. 1B, further illustrates a system comprising various components and devices configured to monitor an operating condition of a battery, and based thereon, determine whether the battery may be undergoing physical/chemical failure, in accordance with at least one embodiment.
FIG. 1C illustrates a system comprising various components and devices configured to monitor an operating condition of a battery, and based thereon, determine whether the battery may be undergoing physical/chemical failure, in accordance with at least one embodiment.
FIGS. 2A and 2B, charts 200A-B present respective measurements and plots over time as a function of how operational health of a battery pack may be determined, in accordance with an embodiment.
FIG. 3 illustrates a flow diagram for a computer-implemented methodology to detect whether a battery pack is undergoing failure, in accordance with at least one embodiment.
FIG. 4 illustrates a flow diagram for a computer-implemented methodology to distribute a battery pack failure warning to various devices and systems, in accordance with at least one embodiment.
FIG. 5 illustrates a flow diagram for a computer-implemented methodology of viable responses to an indication of a battery pack is potentially failing, in accordance with at least one embodiment.
FIG. 6 is a block diagram illustrating an example computing environment in which the various embodiments described herein can be implemented.
FIG. 7 is a block diagram illustrating an example computing environment with which the disclosed subject matter can interact, in accordance with an embodiment.
FIG. 8 presents a table summarizing SAE J3016, detailing respective functions and features during Levels 0-5 of driving automation (per June 2018).

### DETAILED DESCRIPTION

The following detailed description is merely illustrative and is not intended to limit embodiments and/or application or uses of embodiments. Furthermore, there is no intention to be bound by any expressed and/or implied information presented in any of the preceding Background section, Summary section, and/or in the Detailed Description section.

One or more embodiments are now described with reference to the drawings, wherein like referenced numerals are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

It is to be understood that when an element is referred to as being "coupled" to another element, it can describe one or more different types of coupling including, but not limited to, chemical coupling, communicative coupling, electrical coupling, electromagnetic coupling, operative coupling, optical coupling, physical coupling, thermal coupling, and/or another type of coupling. Likewise, it is to be understood that when an element is referred to as being "connected" to another element, it can describe one or more different types of connecting including, but not limited to, electrical connecting, electromagnetic connecting, operative connecting, optical connecting, physical connecting, thermal connecting, and/or another type of connecting.

As used herein, "data" can comprise metadata. Further, ranges A-n are utilized herein to indicate a respective plurality of devices, components, signals etc., where n is any positive integer.

In the various embodiments presented herein, the disclosed subject matter can be directed to identification of pressure build-up during off-gassing of a battery, wherein off-gassing resulting from a potentially destructive chemical/physical breakdown of the battery can be determined compared to off-gassing resulting from normal operation of the battery. In an embodiment, the battery can be a battery pack located onboard a vehicle.

Analysis of a current operational condition of the battery can be compared with a prior operating condition, e.g., current pressure inside a battery pack versus a previously measured operating condition. In the event of the pressure being above a threshold value, extensive analysis of the current operating condition can be undertaken (e.g., temperature, voltage, sensor failure, operational failure of another component onboard the vehicle, and suchlike). In the event of a determination that battery failure occurring or is about to occur, a warning can be generated and transmitted to any of an onboard system, a remotely located device (e.g., a cellphone owned by the operator of the vehicle on which the battery is located), an emergency services system, a battery review system operated by either of the battery manufacturer and/or the vehicle manufacturer, and suchlike. In a further embodiment, in the event that the vehicle on which the battery pack is located is able to operate in an autonomous manner, a navigation system onboard the vehicle can be configured to navigate the vehicle to a safe location (e.g., away from a building) at which the battery failure can be addressed.

Typically, a central ECU or suchlike, is utilized to monitor battery pack operation, but the central ECU can be an unwanted power draw on the battery pack. Hence, an ancillary circuit monitors pressure at the battery pack while the ECU is powered down. In the event of a pressure event occurring at the battery pack that is of concern (e.g., above a threshold), the ECU can be powered back up and configured to compare the current operating condition of the battery pack versus the condition of the battery pack when the ECU was powered down. Based on the analysis by the ECU, the battery pack can be flagged as being operationally satisfactory or flagged as having a problem that requires further activity (e.g., building evacuation, vehicle relocation, fire extinguished, etc.).

It is to be appreciated that while the various embodiments and concepts are presented as directed to lithium-ion battery technologies, the various embodiments and concepts can be equally applied to any battery technology, including battery cells comprising lithium-ion (Li-ion), lithium nickel cobalt Aluminum (NCA), lithium-nickel manganese cobalt (NMC), lithium-manganese Spinel (LMO), lithium Titanate (LTO), lithium-iron Phosphate (LFP), lithium metal polymer (LMP), nickel manganese cobalt (NMC), nickel-metal hydride (Ni-MH), lithium sulphur (Li-S), lead-acid batteries, as well as ultracapacitors, super capacitors, chemical batteries, solid-state batteries, fuel cells, etc.

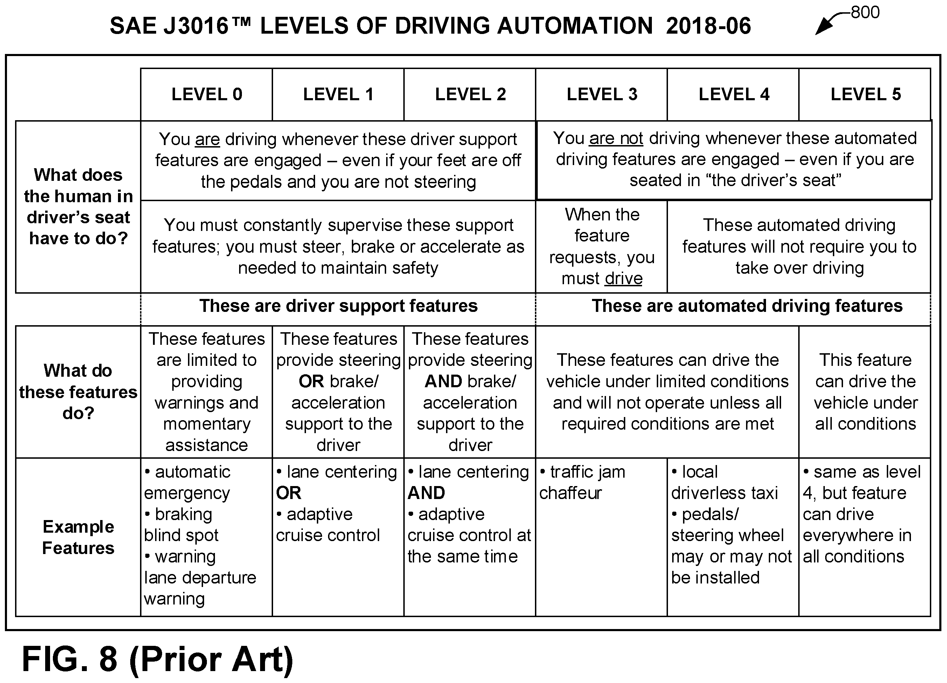

Regarding the phrase "autonomous" operation, to enable the level of sophistication of operation of a vehicle to be defined across the industry by both suppliers and policymakers, standards are available to define the level of autonomous operation. For example, the International Standard J3016 *Taxonomy and Definitions for Terms Related to Driving Automation Systems for On-Road Motor Vehicles* has been developed by the Society of Automotive Engineers (SAE) and defines six levels of operation of a driving automation system(s) that performs part or all of the dynamic driving task (DDT) on a sustained basis. The six levels of definitions provided in SAE J3016 range from no driving automation (Level 0) to full driving automation (Level 5), in the context of vehicles and their operation on roadways. Levels 0-5 of SAE J3016 are summarized below and further presented in FIG. 8, Table 800.

Level 0 (No Driving Automation): At Level 0, the vehicle is manually controlled with the automated control system (ACS) having no system capability, the driver provides the DDT regarding steering, braking, acceleration, negotiating traffic, and suchlike. One or more systems may be in place to help the driver, such as an emergency braking system (EBS), but given the EBS technically doesn't drive the vehicle, it does not qualify as automation. The majority of vehicles in current operation are Level 0 automation.

Level 1 (Driver Assistance/Driver Assisted Operation): This is the lowest level of automation. The vehicle features a single automated system for driver assistance, such as steering or acceleration (cruise control) but not both simultaneously. An example of a Level 1 system is adaptive cruise control (ACC), where the vehicle can be maintained at a safe distance behind a lead vehicle (e.g., operating in front of the vehicle operating with Level 1 automation) with the driver performing all other aspects of driving and has full responsibility for monitoring the road and taking over if the assistance system fails to act appropriately.

Level 2 (Partial Driving Automation/Partially Autonomous Operation): The vehicle can (e.g., via an advanced driver assistance system (ADAS)) steer, accelerate, and brake in certain circumstances, however, automation falls short of self-driving as tactical maneuvers such as responding to traffic signals or changing lanes can mainly be controlled by the driver, as does scanning for hazards, with the driver having the ability to take control of the vehicle at any time.

Level 3 (Conditional Driving Automation/Conditionally Autonomous Operation): The vehicle can control numerous aspects of operation (e.g., steering, acceleration, and suchlike), e.g., via monitoring the operational environment, but operation of the vehicle has human override. For example, the autonomous system can prompt a driver to intervene when a scenario is encountered that the onboard system cannot navigate (e.g., with an acceptable level of operational safety), accordingly, the driver must be available to take over operation of the vehicle at any time.

Level 4 (High Driving Automation/High Driving Operation): advancing on from Level 3 operation, while under Level 3 operation the driver must be available, with Level 4, the vehicle can operate without human input or oversight but only under select conditions defined by factors such as road type, geographic area, environments limiting top speed (e.g., urban environments), wherein such limited operation is also known as "geofencing". Under Level 4 operation, a human (e.g., driver) still has the option to manually override automated operation of the vehicle.

Level 5 (Full Driving Automation/Full Driving Operation): Level 5 vehicles do not require human attention for operation, with operation available on any road and/or any road condition that a human driver can navigate (or even beyond the navigation/driving capabilities of a human). Further, operation under Level 5 is not constrained by the geofencing limitations of operation under Level 4. In an embodiment, Level 5 vehicles may not even have steering wheels or acceleration/brake pedals. In an example of use, a destination is entered for the vehicle (e.g., by a passenger, by a supply manager where the vehicle is a delivery vehicle, and suchlike), wherein the vehicle self-controls navigation and operation of the vehicle to the destination.

To clarify, operations under levels 0-2 can require human interaction at all stages or some stages of a journey by a vehicle to a destination. Operations under levels 3-5 do not require human interaction to navigate the vehicle (except for under level 3 where the driver is required to take control in response to the vehicle not being able to safely navigate a road condition).

As referenced herein, DDT relates to various functions of operating a vehicle. DDT is concerned with the operational function(s) and tactical function(s) of vehicle operation, but may not be concerned with the strategic function. Operational function is concerned with controlling the vehicle motion, e.g., steering (lateral motion), and braking/acceleration (longitudinal motion). Tactical function (aka, object and event detection and response (OEDR)) relates to the navigational choices made during a journey to achieve the destination regarding detecting and responding to events and/or objects as needed, e.g., overtake vehicle ahead, take the next exit, follow the detour, and suchlike. Strategic function is concerned with the vehicle destination and the best way to get there, e.g., destination and way point planning. Regarding operational function, a Level 1 vehicle under SAE J3016 controls steering or braking/acceleration, while a Level 2 vehicle must control both steering and braking/acceleration. Autonomous operation of vehicles at Levels 3, 4, and 5 under SAE J3016 involves the vehicle having full control of the operational function and the tactical function. Level 2 operation may involve full control of the operational function and tactical function but the driver is available to take control of the tactical function.

Accordingly, the term "autonomous" as used herein regarding operation of a vehicle with or without a human available to assist the vehicle in self-operation during navigation to a destination, can relate to any of Levels 1-5. In an embodiment, for example, the terms "autonomous operation" or "autonomously" can relate to a vehicle operating at least with Level 2 operation, e.g., a minimum level of operation is Level 2: partially autonomous operation, per SAE J3016. Hence, while Level 2, partially autonomous operation, may be a minimum level of operation, higher levels of operation, e.g., Levels 3-5, are encompassed in operation of the vehicle at Level 2 operation. Similarly, a minimum Level 3 operation encompasses Levels 4-5 operation, and minimum Level 4 operation encompasses operation under Level 5 under SAE J3016.

It is to be appreciated that while the various embodiments presented herein are directed towards to one or more vehicles (e.g., vehicle 102) operating in an autonomous manner (e.g., as an autonomous vehicle, AV), the various embodiments presented herein are not so limited and can be implemented with a group of vehicles operating in any of an autonomous manner (e.g., Level 5 of SAE J3016), a partially autonomous manner (e.g., Level 1 of SAE J3016 or higher), or in a non-autonomous manner (e.g., Level 0 of SAE J3016). For example, a first vehicle can be operating in an autonomous manner (e.g., any of Levels 3-5), a partially autonomous manner (e.g., any of levels 1-2), or in a non-autonomous manner (e.g., Level 0), while a second vehicle can also be operating in any of an autonomous manner, a partially autonomous manner, or in a non-autonomous manner.

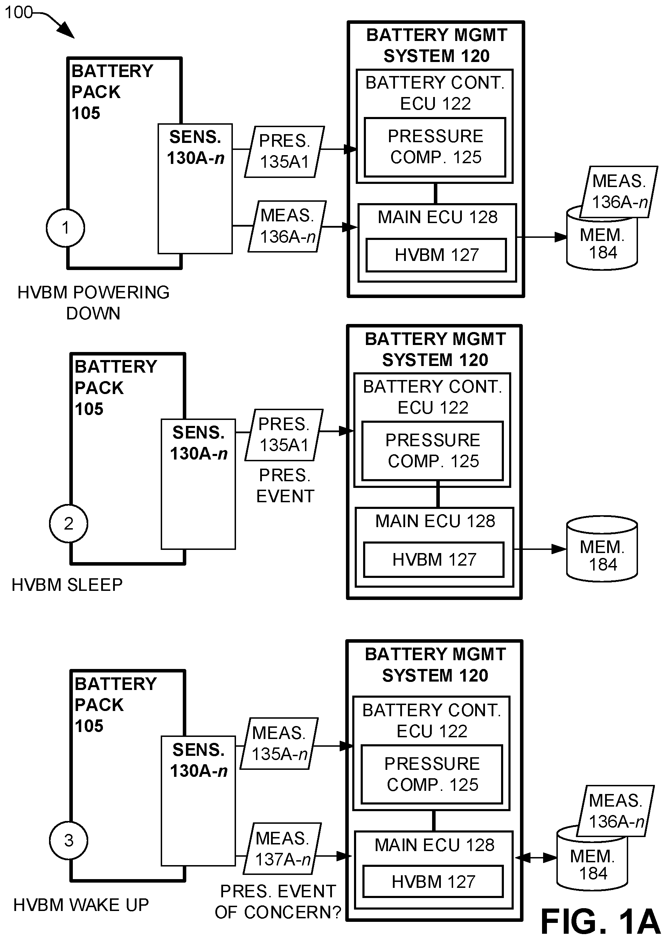

Turning now to the drawings, FIG. 1A illustrates a system 100 comprising various components and devices configured to monitor an operating condition of a battery, and based thereon, determine whether the battery may be undergoing physical/chemical failure, in accordance with at least one embodiment. As shown, system 100 comprises a battery pack 105 connected to a battery management system 120, with a sequence of operations. The battery management system 120 can be configured to monitor operation of the battery pack 105 via sensors 130A-n. As further described, the respective systems and components presented in FIG. 1A can be located on a vehicle (e.g., vehicle 102, as further described). In a conventional system, operation of the battery pack 105 is monitored by the high voltage battery module (HVBM) 127/main electronic control unit (ECU) 128. However, maintaining operation of the HVBM 127 can be an unwanted power drain of the battery pack 105, which can limit range of operation of the vehicle between battery charges. In an embodiment, the HVBM 127 can be placed in sleep/dormant mode, while maintaining oversight of the operational condition of the battery pack 105, e.g., to detect in a timely manner a potential operational event at the battery pack 105 which could potentially lead to failure of the battery pack 105 if not addressed. Hence, a battery control ECU 122 can include a pressure component 125 configured to monitor operation of the battery pack 105 while the HVBM 127 is dormant.

At (1), a series of sensors 130A-*n* are connected to the battery pack 105, wherein the sensors 130A-*n* are configured to monitor various parameters/outputs at the battery pack 105 (e.g., pressure, temperature, voltage, gas particle sensing from the off-gassing, etc.). A pressure sensor 130A1 can be providing a first pressure signal 135A1 to the battery control ECU 122/pressure component 125, while other sensors 135A-*n* are providing measurements 136A-*n* comprising temperature signals, voltage signals, etc., to the HVBM 127, including a second pressure signal. Prior to shut down of the HVBM 127, as part of a shutdown sequence, the various measurements 136A-*n* can be stored, e.g., in an onboard memory device 184.

At (2), with the HVBM 127 in sleep mode, the battery control ECU 122/pressure component 122 maintains monitoring of the pressure at battery pack 105. In an embodiment, maintaining oversight of the pressure at the battery pack 105 enables any off-gassing events to be detected, as well as a build-up in pressure resulting from failure of the battery pack 105. As further described, the pressure component 125 can be configured to monitor the pressure signal 135A1 to detect a change in sensor signal 135A1 from a baseline value. In response to detecting a change in the magnitude of the sensor signal 135A1, e.g., a spike of signal 105 Kilopascals (KPa) is detected against a baseline signal of 100KPa, the pressure component 125 can be configured to wake up the HVBM 127.

At (3), upon wake up, the HVBM 127 can be configured to capture the current operating condition of the battery pack 105, per measurements 137A-*n*. The HVBM 127 can be further configured to compare the measurements 136A-n recorded at shut down of the HVBM 127 with the measurements 137A-*n* recorded at wakeup of the HVBM 127. Hence, as further described, using the pressure component 125 to monitor the pressure 135A1 in conjunction with the HVBM 127 being configured to compare shutdown measurements 136A-*n* with wakeup measurements 137A-*n* enables monitoring of the battery pack 105 to expeditiously detect a potential anomaly in a pressure state at the battery pack 105, as well as efficient operation of the HVBM 127.

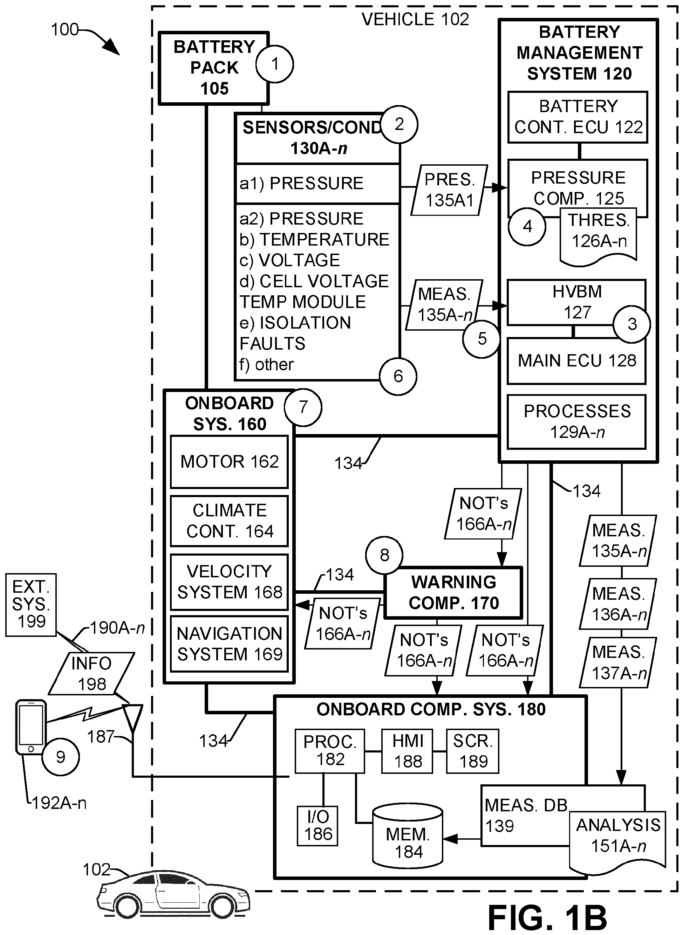

FIG. 1B further illustrates system 100 comprising various components and devices configured to monitor an operating condition of a battery, and based thereon, determine whether the battery may be undergoing physical/chemical failure, in accordance with at least one embodiment. As shown, system 100 comprises a vehicle 102 with a battery pack 105 located thereon, wherein the battery pack 105 can be configured to provide power to propel the vehicle 102, power onboard systems 160, and suchlike. In an embodiment, battery pack 105 can be formed from one or more battery cells, wherein the one or more battery cells can be Li-ion battery cells.

As mentioned, in an embodiment, system 100 can further include a battery management system 120 configured to monitor, control, analyze, and/or diagnose operation of the battery pack 105. Further, system 100 can include various sensors 130A-*n* configured to monitor one or more variables/parameters/conditions (e.g., sensor signals/measurements 135A-*n*, 136A-*n*, 137A-*n*) pertaining to operation of the battery pack 105. Any suitable sensor 130A-*n* can be utilized regarding the variable/parameter to be measured, e.g., analog sensor, digital sensor, and suchlike. The one or more parameters/conditions monitored by sensors 130A-*n* can include, in a non-limiting list, at least one of (a) pressure within the battery pack, (b) temperature of the battery pack, (c) output voltage/current/capacity of the battery pack, (d) operating/fault condition of one or more sensors connected to the battery, (e) inter-system communications such as cell voltage temperature node (CVTN) communication(s), (f) operating/fault condition of one or more systems, components, and/or devices co-located on vehicle 102 with battery pack 105 and battery management system 120 (f) and other pertinent issues/sources of concern. As further described herein, the battery management system 120, and the respective components included therein, can be configured to monitor the one or more sensors 130A-*n*, from which the battery management system 120 can further determine the operational health of the battery pack 105. As further described, the battery management system 120 can include a battery control electronic control unit (ECU) 122 with a pressure component 125 (aka a sensor component) incorporated therein and a high voltage battery module (HVBM) 127 and associated main ECU 128. The battery management system 120 can further include various processes 129A-*n* (e.g., functions, operations, algorithms, etc.) configured to assist operation of the various components included in the battery management system 120 and further, for application/utilization across vehicle 102. The battery control ECU 122/pressure component 125 can be configured to communicate with the HVBM 127/ECU 128 via interfaces 121A and 121B (per FIG. 1B).

System 100 can further include various onboard systems 160 for which the battery pack 105 is configured to provide power, e.g., a motor system 162, a climate control system 164, a velocity system 168, a navigation system 169, and suchlike. The motor system 162 can be configured to control operation, e.g., start/stop, of a motor configured to propel the vehicle 102. The climate control system 164 can be configured to control operation of an air conditioning, heating, etc., to control the operational climate of a passenger compartment onboard vehicle 102. The velocity system 148 can be configured to brake/slow down or stop the vehicle 102 (e.g., when parking/parked, etc.). The velocity system 148 can also be configured to control acceleration of the vehicle 102 wherein braking and acceleration of the vehicle 102 can form part of the DDT operational function, as previously described. The velocity system 148 can be further configured to receive data pertaining to motion of vehicle 102 regarding at least one of velocity, deceleration, stationary, braking, acceleration, and suchlike, (e.g., as generated by a motion/velocity sensor). The navigation system 169 can be configured to navigate vehicle 102 along a road as well as to control steering of the vehicle 102. It is to be appreciated that while described herein respectively as motor system 162, climate control system 164, velocity system 168, and navigation system 169, the term "system" herein can also be used to describe a computer executable component (that can be stored in memory and executable by a processor) located at the respective system to control operation of the respective system and further interact with other systems.

As further described herein, failure of a component (e.g., a sensor 130A-*n*), as well as failure at any of various onboard systems 160 may impact a determination of the operational health of the battery pack 105, with the component/system failure determined and isolated as part of the analysis of the operational health of the battery pack 105.

System 100 can further include a warning component 170. In the event of a determination (e.g., by battery management system 120) of battery pack 105 is undergoing operational failure, the warning component 170 can be further configured to generate and transmit a series of warnings to alert one or more entities regarding the potential/ongoing failure of the battery pack 105. As further described, the warnings can be transmitted to various onboard systems/components, as well as remotely located devices 192A-*n* and external system(s) 199.

In a further embodiment, system 100 can further include an onboard computer system (OCS) 180 comprising a processor 182 and a memory 184, wherein the processor 182 can execute the various computer-executable components, functions, operations, etc., presented herein. The memory 184 can be utilized to store the various computer-executable components, functions, code, etc., as well as battery measurements 135A-*n*/136A-*n*/137A-*n*, in database 139, content of notifications/warnings 166A-*n*, processes 129A-*n*, thresholds 126A-*n*, information 198 shared externally, and suchlike (as further described herein).

As further shown, OCS 180 can include an input/output (I/O) component 186, wherein the I/O component 186 can be a transceiver configured to enable transmission/receipt of information and data (e.g., notifications 166A-*n* in packets of information 198) between vehicle 102 and other systems and devices presented in system 100 (e.g., user devices 192A-*n*, external system 199, and suchlike). I/O component 186 can be communicatively coupled, via an antenna 187, to the remotely located devices and systems. Transmission of data and information between the vehicle 102 (e.g., via antenna 187 and I/O component 186) and further between any of the remotely located devices 192A-*n* and systems 199 can be via the signals 190A-*n*. Any suitable technology can be utilized to enable the various embodiments presented herein, regarding transmission and receiving of signals 190A-*n*. Suitable technologies include BLUETOOTH^{®}, cellular technology (e.g., 3G, 4G, 5G), internet technology, ethernet technology, ultra-wideband (UWB), DECAWAVE^{®}, IEEE 802.15.4a standard-based technology, Wi-Fi technology, Radio Frequency Identification (RFID), Near Field Communication (NFC) radio technology, and the like.

In an embodiment, the OCS 180 can further include a human-machine interface (HMI) 188 (e.g., a display, a graphical-user interface (GLTI)) which can be configured to present various information including any of notifications 166A-*n*, information received from onboard and external systems and devices, etc., per the various embodiments presented herein. The HMI 188 can include an interactive display 189 to present the various information (e.g., in notifications 166A-*n*) via various screens presented thereon, and further configured to facilitate input of information/settings/etc., regarding operation of the vehicle 102.

The various systems/components located onboard vehicle 102 (e.g., the battery pack 105, e.g., via a wiring harness/sensor bundle; the battery monitoring system 120; the onboard systems 160; the warning component 170; OCS 180; and suchlike) can be communicatively coupled via an onboard computer network/communication bus 134. Network/bus 134 can be any suitable vehicle-borne, embedded system, for example, FLEXRAY, Controller Area Network (CAN), Ethernet, Local Interconnect Network (LIN), and suchlike.

While one or more devices and/or systems are described below with reference to an EV, such as an automobile, the one or more embodiments described herein are not limited to this use. For example, one or more embodiments presented herein can be utilized to monitor/control operation of a battery, wherein the battery may be located on a military vehicle, railroad vehicle, a marine vehicle such as a boat, ship, submarine, or marine drone, a winged vehicle such as a plane or drone, and/or a rotored vehicle such as a helicopter or drone. Likewise, one or more embodiments presented herein can be extended to monitoring operation of a battery located on a robot and/or any suitable moving or stationary device. Other applicable applications include scooters, Segway^{®}, electric bicycles, E-rickshaws, and the like. Further, one or more embodiments presented herein can be utilized to control charging of a battery, wherein the battery is a standalone device, e.g., the battery is not located on a vehicle, device, etc.

Further, the embodiments can be applied to any vehicle utilizing a battery charging system, e.g., a Battery Electric Vehicle (BEV) where the powerplant is only an electric motor powered by a battery and the battery is recharged via an external charging station, a Hybrid Electric Vehicle (HEV) having both a gasoline/petrol engine & fuel tank and an electric motor powered by a battery, wherein operation of the HEV recharges the battery (e.g., via a regenerative braking system capturing kinetic energy), a Plug-in Hybrid Electric Vehicle (PHEV) having both a gasoline/petrol engine & fuel tank and an electric motor powered by a battery, wherein the battery can be charged via an external charging station, and the like.

To enable further understanding of the various components and a possible sequence of activities utilized in the various embodiments presented herein, the various systems, components, operations, and suchlike, are presented in a step-thru like manner.

At (1), battery pack 105 is located on vehicle 102 to provide electrical power for the various systems and component located on vehicle 102. As previously mentioned, battery pack 105 can be a Li-ion battery, however, the various embodiments presented herein can be directed towards any battery pack/device that may exhibit failure through a single parameter/measure. For example, the various embodiments presented herein relate to detecting failure of the battery pack 105 as a function of a determined change in pressure within the battery pack 105. In another embodiment, the single parameter may be temperature, voltage, etc.

At (2), during operation of the battery pack 105, e.g., during provision of power by the battery pack 105 to drive motor 162, the various sensors 130A-*n* connected to and/or monitoring operation of the battery pack 105 can be generating measurements 135A-*n* regarding any of (a) pressure within the battery pack, (b) temperature of the battery pack, (c) output voltage/current/capacity of the battery pack, (d) operating/fault condition of one or more sensors connected to the battery, (e) operating/fault condition of one or more systems/components/devices co-located with battery pack 105 and battery monitoring system 120, and suchlike, as previously mentioned. The respective measurements 135A-*n* can be stored/captured in a battery measurements database 139, wherein the measurements database 139 can be located in memory 184 and updated as necessary. Depending upon the particular moment, measurements 135A-*n* are labeled herein as 136A-*n* (e.g., at shutdown of HVBM 127) and 137A-*n* (e.g., at wake-up of HVBM 127). Further, a pressure sensor connected to the pressure component 125 is labelled herein as sensor 130A1, while a pressure sensor connected to the HVBM is labelled sensor 130A.

At (3), the battery management system 120 can include various components such as the battery control ECU 122 which can be configured to monitor the operational condition of the battery pack 105 (e.g., receives and processes measurements 135A-*n* from sensors 130A-*n*) as well as monitors inputs and outputs to and from battery pack 105. In an embodiment, while vehicle 102 is powered, the pressure component/module 125 in the battery control ECU 122 can be configured to solely monitor pressure 135A1 at the battery pack 105 while other variables/measures 135A-*n* (e.g., temperature, voltage, etc.) are not measured by the battery control ECU 122/pressure component/module 125.

As mentioned, the battery management system 120 can further include the HVBM 127 which can be configured to control power flow to and from the battery pack 105 and further maintain power levels across the battery pack 105. As part of controlling power operation(s) at the battery pack 105, HVBM 127 performs analysis (e.g., per analysis 151A-*n*) of the operating condition of the battery pack 105 as a function of the various measurements 135A-*n* (e.g., including pressure 135A). However, for the HVBM 127 to monitor the operating condition of battery pack 105, vehicle 102's main electronic control unit (ECU) 128 for the entire vehicle 102 is required to remain powered up and operational, e.g., as a function of enabling HVBM 127 to monitor/determine power requirements of the respective onboard systems 160 and the corresponding power draw of battery pack 105.

Having the HVBM 127/main ECU 128 powered up by battery pack 105 while vehicle 102 is parked can be a waste of power resources provisioned by the battery pack 105, which can further limit the operational range of vehicle 105. However, the battery control ECU 122 can require much less power to remain operational, per the various embodiments presented herein, than the HVBM 127/ECU 128 as the battery control ECU 122 is only performing measurement/analysis of the pressure measurements 135A1 compared to the wide range of analyses and measurements the HVBM 127/ECU 128 perform across the onboard systems 160 (e.g., per analysis 151A-*n*).

As part of a shutting down process of vehicle 105 (e.g., during parking) the final battery measurements 136A-*n* (e.g., received by battery control ECU 122) can be stored in the measurements database 139. As further described, upon restarting/waking up the HVBM 127, the final battery measurements of 136A-*n* can be compared with new/current battery measurements 137A-*n*.

Hence, as further described, compared with conventional systems, review of the operational condition of the battery pack 105 can be expedited based upon a trigger (e.g., a pressure measurement 135A1 is of concern) initiates review of the previously stored battery measurements 136A-*n* with the current battery measurements 137A-*n*.

At (4), with vehicle 102 powered down, HVBM 127 can also be powered down. However, operation of the battery control ECU 122 can remain operational with the pressure component 125 monitoring pressure signals 135A1 (and 136A, 137A) via sensor 130A1 at the battery pack 105. While vehicle 105 is powered down, by measuring the pressure 135A1, the pressure component 125 can, over time generate a baseline operating condition, against which a deviation in pressure can be ascertained, e.g., regarding magnitude, slope of a plot of values, etc., per a threshold 126A-*n*.

At (5), in the event of a currently received pressure measurement 135A1 is of concern (e.g., measurement deviates too far from a baseline condition, per threshold 126A-*n*), the pressure component 125/battery control ECU 122 can be configured to wake-up the HVBM 127. Upon waking, the HVBM 127 can be configured to obtain and compare current measurements 137A-*n* with the previously stored measurements 136A-*n* (e.g., the measurements stored in database 139 when the HVBM 127 was powered down.

At (6), as previously mentioned, while the HVBM 127 is powered down, only the pressure measurements 135A1 are being monitored by the pressure component 125/battery control ECU 122. However, upon waking, HVBM 127 can be configured to re-source measurements from all the sensors 130A-*n*, as well as determine a current operating condition of any of the sensors 130A-*n*, and further, a condition at any of the onboard systems 160 (e.g., as conveyed across bus 134) that may give rise to a spurious signal in the measurements 135A-*n*/136A-*n*/137A-*n*.

At (7), one of the measurements 135A-*n* of concern is (e) isolation faults, wherein the HVBM 127 can be configured to review operation of the other onboard systems 160 to determine whether a potential event of interest was generated by an effect elsewhere across the onboard system 160 unrelated to an operational state of battery pack 105. For example, a transient electrical effect may occur at any of the onboard systems 160 and owing to the interconnectedness (e.g., wiring harnesses, bus 134, etc.) of the various onboard systems 160, the transient electrical effect originating at, for example, motor 162, may give rise to an electrical event at battery pack 105, sensors 130A-*n*, and/or measures 135A-*n*. Accordingly, what may initially appear to be a spike in pressure 135A1 is the result of an effect from elsewhere, such as a short-circuit elsewhere in the high voltage circuit. As part of the analysis 151A-n of the various measurements 135A-*n*, 136A-*n*, and/or 137A-*n*, HVBM 127 can be configured to isolate the effect/fault (e.g., as (e) isolation fault(s)) arising from an onboard system 160 that is not related to the operational condition of battery pack 105.

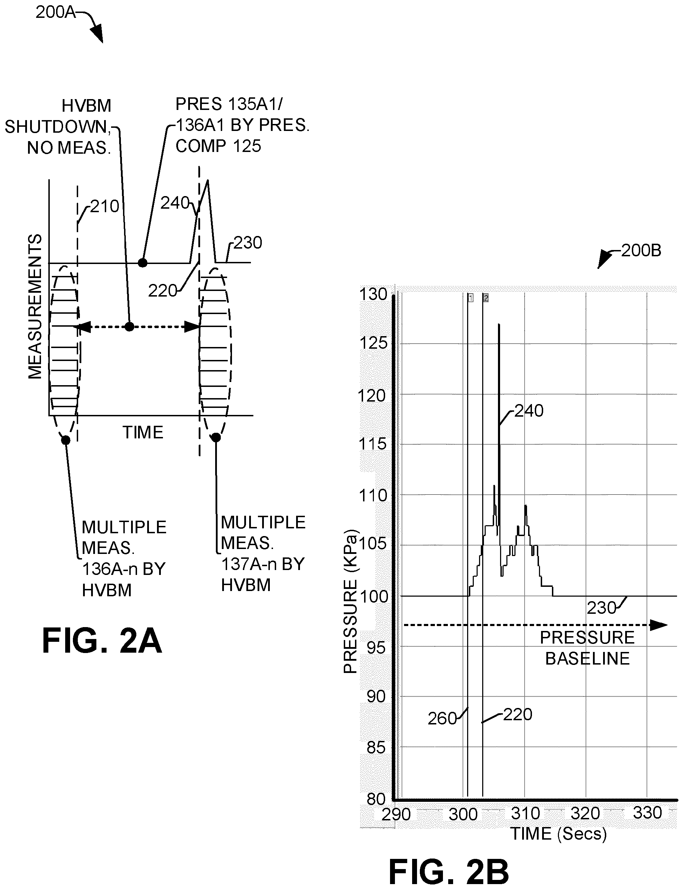

At (8), in the event of analysis 151A-*n* by HVBM 127 regarding any of measurements 135A-*n*, 136A-*n*, 137A-*n*, sensors 130A-*n*, etc., HVBM 127 determines that, in a non-limiting list, (a) the circumstances of the pressure event indicate that the pressure event can be explained (e.g., results from unrelated event at onboard systems 160), (b) was of insufficient magnitude/duration to be of concern, (c) other parameters/measurements 135B-*n* indicate that the battery pack 105 is operating correctly, (d) and suchlike, HVBM 127 can be configured to power itself down while the battery control ECU 122 is configured to remain operational to continue to monitor future pressure signals 135A1 received from sensor 130A. In an embodiment, the HVBM 127 can update the measurements database 139 with an entry (e.g., in a notification 166M) detailing analysis 151A-*n* conducted by HVBM 127 in determining the pressure event (e.g., pressure event 240, per FIGS. 2A-2B) was deemed to not be of concern. In an embodiment, the notification 166M, analysis/review 151A-*n* by HVBM 127, and any of associated measurements 135A-*n*, 136A-*n*, and/or 137A-*n*, can be transmitted to an external system 199 for further review, as described in (9) below.

In another embodiment, in the event of analysis 151A-*n* by HVBM 127 that battery pack 105 does appear to be/is failing, HVBM 127 can be configured to generate and transmit a warning/alert notification 166A-*n* (e.g., *"thermal event occurring"* at battery pack 105) that the operational condition of the battery pack 105 is of concern. The warning notification 166A-*n* can be received and processed by the warning component 170. The warning component 170 can be configured to generate further notifications to respective components/systems/entities.

At (9), in an embodiment, the warning component 170 can be configured to transmit a warning notification 166A-*n* to a remotely located entity/system. For example, the warning component 170 can be configured to transmit (e.g., via I/O 186, antenna 187, and signals 190A-*n*) a warning notification to a device 192A-*n*, wherein the device 192A-*n* can be a cellphone, tablet computer, an alarm system incorporated into a building where the vehicle 102 is currently located, e.g., a home alarm system at which vehicle 102 is parked, and suchlike. In response to receiving the warning notification 166A-*n*, the device 192A-*n* can be configured to alert the owner of the device 192A-n, wherein the alert can be an audible alarm such as a ringtone, a digital message *"vehicle battery failure",* a visual notification presented (on a screen) on the device 192A-*n*, and suchlike. In response to generation of the alarm, one or more persons who are in vicinity of the vehicle can undertake appropriate action such as attempt to address the failure of the battery pack 105 (e.g., extinguish fire, reposition vehicle, alert the emergency services, and suchlike). In a further embodiment, the home alarm system (or any closed-circuit video/television system) can be configured to operate/direct a field of view of one or more cameras in the direction of vehicle 102 and obtain video of the vehicle, e.g., to determine whether vehicle 102 or the battery pack 105 is on fire as a function of the failure of battery pack 105. The video/digital imagery captured by the home alarm system can be processed and transmitted to the owner (e.g., via device 192A-n) of the vehicle/property where the vehicle is located to enable determination of whether vehicle 102 is on fire, and a suitable response (e.g., vacate premises, extinguish fire, cool battery pack 105, and suchlike). Further, the video/digital imagery captured by the home alarm system can be processed and transmitted to an entity operating the external system 199, e.g., where external system 199 is operated by one or more emergency services, manufacturer of battery pack 105, manufacturer of vehicle 102, and suchlike.

In another embodiment, the warning component 170 can be configured to transmit the warning notification 166A-*n* to an external system 199, wherein the external system 199 can be operated by an emergency service (e.g., fire service) that can deploy one or more entities to the location of vehicle 102 to address the failing battery pack 105 (e.g., extinguish a fire). In a further embodiment, the external system 199 can be operated by an entity involved with operation of the battery pack 105 (e.g., a manufacturer of the battery pack 105) and/or operation of vehicle 102 (e.g., manufacturer of vehicle 102). The respective entity operating external system 199 can utilize the notification 166A-*n*, analysis/review 151A-*n* by HVBM 127, and any of associated measurements 135A-*n*, 136A-*n*, and/or 137A-n, to further knowledge regarding operation and use of battery pack 105. For example, the notification 166A-*n* can include information that increases understanding (e.g., by the battery manufacturer or the vehicle manufacturer) of conditions that may lead to failure of battery pack 105, e.g., for issues regarding potential battery recall.

In another embodiment, the external system 199 can be located on a second vehicle operating proximate to the first vehicle, vehicle 102, wherein the first vehicle and second vehicle can engage in vehicle-to-vehicle communications (e.g., via I/O 186, antenna 187, information 198, etc.). In an embodiment, the first vehicle and/or the second vehicle can be operating in at least a partially autonomous manner. The warning component 170 can be configured to transmit the warning notification 166A-*n* from the first vehicle to the external system 199 located on the second vehicle. In an embodiment, the warning notification 166A-*n* can be an instruction to the second vehicle to avoid the first vehicle, e.g., in view of the battery pack 105 potentially undergoing failure. In another embodiment, the warning notification 166A*n* can be an instruction to the second vehicle requesting the second vehicle to assist the first vehicle, e.g., to enable conveyance of persons that were originally being conveyed by the first vehicle.

In a further embodiment, warning component 170 can be configured to generate and transmit a warning notification 166A-*n* to one or more of the onboard systems 160. For example, notification 166A-*n* can be transmitted to the navigation system 169. The navigation system 169 can be further configured to, upon receipt of the notification 166A-*n*, interact with the motor system 162 and the velocity system 168 (e.g., via an onboard ECU, such as OCS 180) to start up and cause vehicle 102 to autonomously reposition itself to a safer location (e.g., OCS 180 is configured to interact with a home security system to open a garage door to a home garage in which vehicle 102 is currently parked, and reposition vehicle 102 on the driveway/street to reduce likelihood of a fire initiated by failure of battery pack 105 causing loss of life and/or property. For example, by autonomously repositioning vehicle 102, buys time for one or more residents of the house at which that vehicle 102 is located to exit the house, address the battery failure 105, and suchlike.

In another embodiment, the warning component 170 can be configured to transmit the warning notification 166A-*n* to the HVBM 127. In response to receipt of the warning notification 166A-*n*, the HVBM 127 can be configured to disable ability to re-charge the battery. In a further embodiment, the warning component 170 can be configured to transmit the warning notification 166A-*n* to the climate control system 164. In response to receipt of the warning notification 166A-n, the climate control system 164 can be configured to disable any further climate control operations, thereby reducing power draw from the battery pack 105 and not operationally stressing the battery pack 105. In another embodiment, the warning component 170 can be configured to transmit the warning notification 166A-*n* to any of the velocity system 168, the motor system 162, the navigation system 169, and suchlike, to limit operation of the vehicle 102 to an operation that does not operationally stress the battery pack 105. For example, operation of the vehicle 102 can be limited to a velocity that does not operationally stress the battery pack 105, such that the vehicle 102 is constrained to a "limphome" mode of operation.

In a further embodiment, the warning component 170 can be configured to present the warning notification 166A-*n* on the HMI 188/screen 189 located in the vehicle 102, e.g., in the dashboard cluster in the passenger compartment. The warning notification 166A-*n* can be configured to present various options to the driver/occupant of vehicle 102, e.g., *"stop and exit the vehicle", "drive vehicle to nearest dealer*/*repair station",* and suchlike.

In an embodiment, any of the devices 192A-*n* and/or external system 199 can be configured to receive an input/feedback (e.g., by owner of vehicle 102, an operator of the external system 199) indicating that after being reviewed (e.g., by a human and/or a remotely located process), the one or more warning notifications 166A-*n* respectively received at the device 192A-*n*/external system 199 were false, and the battery pack 105 is not undergoing failure. Accordingly, the feedback can be utilized to improve the ability of the processes 129A-*n* and application of thresholds 126A-*n* to determine/identify operating conditions at the battery pack 105 that can lead, and may not lead, to a correct/accurate determination that the battery pack 105 is, or is not, about to undergo, or is undergoing, operational failure.

In another embodiment, in the event of diagnosis by HVBM 127 that a sensor 130A-*n* may have failed/be operating inconsistently, a warning notification 166A-*n* can be generated indicating the sensor 130A-*n* has an issue and the owner of the vehicle 102 (e.g., via device 192A-*n*) can be directed to have the sensor 130A-*n*/battery pack 105 checked (e.g., by a manufacturer service station/dealer) as soon as possible to correct the potential fault. Further, a warning notification 166A-*n* can be generated instructing the owner of the vehicle 102 to not charge the battery pack 105 until the potential issue has been resolved (e.g., faulty sensor 130A1 replaced).

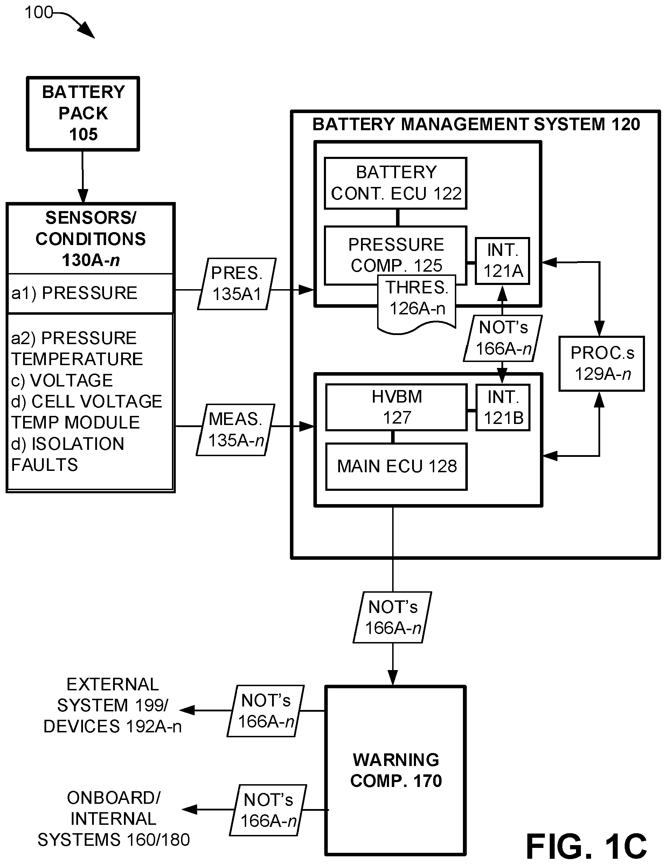

FIG. 1C, further illustrates system 100 comprising various components and devices configured to monitor an operating condition of a battery, and based thereon, determine whether the battery may be undergoing physical/chemical failure, in accordance with at least one embodiment. In an embodiment, a first pressure sensor 130A1 can be monitoring pressure (e.g., pressure (a1) at the battery pack 105, wherein the pressure sensor 130A1 can be connected to the battery control ECU 122/pressure component 125 and is providing first pressure values 135A1. Further, as shown, a second pressure sensor 130A can be included in the bundle of sensors 130A-*n* generating measurements 135A-*n* for analysis by HVBM 127/main ECU 128, wherein the measurements 135A-*n* (and also measurements 136A-*n*/137A-*n*) can include a second pressure measure 135A that is comparable to first pressure value 135A1 (e.g., both are received from a pressure sensor 130A1, 130A monitoring operational pressure of the battery pack 105). Hence, when the HVBM 127/ECU 128 is powered down, the battery control ECU 122/pressure component 125 is still operational, receiving and performing analysis on the pressure measurements 135A1. In an embodiment, as a fail-safe, the battery control ECU 122/pressure component 125 can be configured, such that if there is a failure of sensor 130A1, or at the battery control ECU 122/pressure component 125 itself, the battery control ECU 122/pressure component 125 can be configured to transmit a notification 166A-*n* to the HVBM 127 to wake up and monitor the battery pack 105 as any of the sensor 130A1, battery control ECU 122/pressure component 125 has failed.

As shown in FIG. 1C, the battery control ECU 122/pressure component 125 can be communicatively coupled to the HVBM 127/ECU 128 via interface components 121A and 121B, with notifications 166A-*n* being transmitted therebetween. E.g., a notification 166W can be generated and transmitted from interface component 121A in the event of the pressure component 125 determining that a pressure event is occurring and the HVBM 127 is required to wake up and monitor the sensors 130A-*n*, as previously described. In an embodiment, interface 121B can be configured to remain operational while HVBM 127/ECU 128 are powered down, enabling the interface 121B to monitor operation of the battery control ECU 122/pressure component 125. In the event of a failure (e.g., communications failure) of the battery control ECU 122/pressure component 125, the failure can be detected by the interface 121B and further, in response to detecting the failure, the interface 121B can be configured to wake the HVBM 127/ECU 128 to enable the HVBM 127/ECU 128 to monitor operation of the battery 105 while the failure of any of the battery control ECU 122/pressure component 125/pressure sensor 130A1 are being addressed. In an embodiment, interface 121A can be configured to generate and transmit a notification 166C to interface 121B at a predefined interval, e.g., every 5 seconds, 10 seconds, and suchlike. The interface 121B can be configured to receive the communication notification 166C, and in response to interface 121B not receiving the notification 166C at the predefined time, interface 121B can be further configured to wake HVBM 127 to monitor battery pack 105 in the event of battery control ECU 122/pressure component 125 having potentially failed.

Turning to FIGS. 2A AND 2B, FIGS. 2A and 2B, charts 200A-B present respective measurements and plots over time as a function of how operational health of a battery pack may be determined, in accordance with an embodiment. FIG. 2A illustrates the respective operational components and respective parameters being measured, while FIG. 2B presents a determination of a pressure measurement triggering further monitoring.

As shown in FIG. 2A, initially a HVBM 127 is monitoring a plethora of parameters (e.g., via sensors 130A-*n*, measurements 136A-n). At moment 210, operation of vehicle 102 is shutdown (e.g., parked) with an associated shut down of HVBM 127. As part of the shutdown, HVBM 127 can be configured to store/identify a set of sensor measurements 136A-*n* in the measurements database 139 as being pre-shutdown values. At moment 210, as previously mentioned, a pressure component 125 can be configured to further monitor pressure 136A1 (or 135A1), comparing a baseline value with a threshold 126A-*n*. At a subsequent time 220, in response to the pressure 136A1 equals or exceeds threshold 126A-*n* (e.g., at pressure spike 240), operation of the HVBM 127 can be re-initiated. Upon re-initiation of operation of HVBM 127, the plethora of parameters can be monitored once more (e.g., as measurements 137A-*n*). The HVBM 127 can be configured to compare measurements 136A-*n* (pre-shutdown) with measurements 137A-*n* (post-shutdown), and determine whether the battery pack 105 is undergoing, or potentially undergoing, failure.

As shown in FIG. 2B, plot 230 is a plot of pressure (KPa, y-axis) versus time (x-axis). As previously mentioned, any number of approaches/techniques can be utilized to identify a pressure event 240 of concern. As further mentioned, the battery control ECU 122 (e.g., via pressure component 125) can maintain monitoring of the pressure sensor 130A1, while the other sensors 130A-n are not monitored as HVBM 127 is currently powered down/dormant, at moment 210. Accordingly, the battery control ECU 122 can generate a pressure baseline 230.

The baseline pressure 230 can be affected by the environmental conditions where vehicle 102 is currently located. For example, at sea level, a pressure measurement 135A1/136A1/137A1 of the battery pack 105 may be ~100KPa, while at 1000m above sea level, the pressure measurement 135A1/136A1/137A1 of the battery pack 105 may be ~90KPa, and further, at 3000m above sea level, the pressure measurement 135A1/136A1/137A1 of the battery pack 105 may be ~70KPa. Further, weather conditions at the current location of vehicle 102 can cause a change in pressure at the battery pack 105. For example, a shift in weather conditions from low pressure to high pressure may cause a corresponding change in pressure measurement 135A1/136A1/137A1 at the battery pack 105 of ~10KPa. However, such differences in pressure resulting from environmental effects, and suchlike, can take an appreciable/extended amount of time for the pressure transition to occur (e.g., a gradual increase/decrease of the baseline) versus the typically rapid increase in pressure 135A1 at the battery pack 105 when either the battery pack 105 is off-gassing and/or undergoing failure/breakdown. Per the example pressure measurements 135A1 presented chart 200B, the measured pressure (e.g., baseline pressure) is ~100KPa. As shown, at point 260 (e.g., 301 seconds) the measured pressure 135A begins to rise, and further, at point 220 (e.g., at 303 seconds) the measured pressure 135A is 105KPa. In the example presented in FIG. 2B, a threshold 126A-*n* can be defined and applied to the analysis of the measured pressures 135A1/136A1. In the example, threshold 126A-*n* has been set to a preconfigured pressure alert value of to 5KPa. As shown, the change in pressure value from the baseline of 100KPa to 105KPa can be detected in 2 seconds. With the change in pressure 135A1 (e.g., between point 260 and 220) detected by the battery control ECU 122, as previously mentioned, the battery control ECU 122 can be configured to wake-up the HVBM 127 (e.g., at moment 220). Depending upon the particular HVBM 127 located on vehicle 102, waking of the HVBM 127 may take 3-10 seconds.

Upon wake-up, as previously described, HVBM 127 can immediately obtain current parameter measurements 137A-*n*, access the previously stored measurements 136A-*n* (e.g., stored in the measurements database 139), and conduct comparison/analysis/review 151A*n* of the measurements 136A-*n* and 137A-*n*. Hence, even with a wake-up delay of 10 seconds at HVBM 127, in the example presented in FIG. 2B, HVBM 127 is determining whether battery pack 105 is undergoing failure/breakdown within 13 seconds of the potential failure being present in the pressure measurements 137A-*n*. Hence, per the various embodiments presented herein, a failure of battery pack 105 can be rapidly detected which can be critical in enabling the battery pack 105 failure to be addressed, people to evacuate a building housing vehicle 102, and suchlike.

As mentioned, any suitable technique can be utilized to determine a change in pressure at battery pack 105, for example, in a non-limiting list: a) an average of pressure measurements 135A1/136A1 over a first duration (e.g., for the last 30 secs, 1 minute, 5, minutes, 30 minutes, a baseline condition, and suchlike) can be compared with an average of pressure measurements 135A1/136A1 over a second duration (e.g., over the last 5 secs, 10 seconds, 1 minute, duration of change from a baseline, and suchlike), b) a maximum pressure value in pressure measurements 135A1/136A1 over a first duration versus maximum pressure value in pressure measurements 135A1/136A1 over a second duration, c) a slope of a first portion of a plot (e.g., pre-point 260 of plot 230) derived from pressure measurements recorded during a first time period and a slope of a second portion of a plot (e.g., between points 260 and 220 of plot 230) derived from pressure measurements recorded during a second time period, d) a percentage shift from the baseline values, e) and suchlike. In the example scenario presented in FIGS. 2A and 2B, the pressure component 125 was configured with a detection value/threshold 126A-*n* of 5KPa, with the change in pressure detected at 220. However, it is to be appreciated that the detection value presented of 5KPa is arbitrary and pressure component 125 can be configured with any suitable/applicable value, e.g., in accordance with detecting a change in the pressure magnitude from the baseline value.

In the event of a sensor 130A-*n* failing between the recording of the previously stored measurements 136A-*n* and current parameter measurements 137A-*n*, the sensor failure can be determined by the HVBM 127 owing to a lack of presence of a parameter measurement in measurements 137A-*n* for the sensor 130A-*n* that has failed. The HVBM 127 can conduct further analysis 151A-*n* to determine whether the sensor 130A-*n* is an isolated event (e.g., the other measurements 137A-*n* vs. 136A-*n* indicate the battery pack 105 is not failing) or is indicative of the battery pack 105 failing.

As used herein, the terms "infer", "inference", "determine", and suchlike, refer generally to the process of reasoning about or inferring states of the system, environment, and/or user from a set of observations as captured *via* events and/or data. Inference can be employed to identify a specific context or action, or can generate a probability distribution over states, for example. The inference can be probabilistic-that is, the computation of a probability distribution over states of interest based on a consideration of data and events. Inference can also refer to techniques employed for composing higher-level events from a set of events and/or data. Such inference results in the construction of new events or actions from a set of observed events and/or stored event data, whether or not the events are correlated in close temporal proximity, and whether the events and data come from one or several event and data sources.

The processes 129A-*n* can include computer-based machine learning, artificial intelligence, and reasoning techniques and technologies that employ probabilistic and/or statistical-based analysis to prognose or infer an action that a user desires to be automatically performed. The various embodiments presented herein can utilize various machine learning-based schemes for carrying out various aspects thereof. For example, a process for determining whether a pressure event 240 is indicative of a battery pack 105 is undergoing failure, can be facilitated via an automatic classifier system and process.

A classifier is a function that maps an input attribute vector, *x* = (*x1, x2, x3, x4, xn*)*,* to a class label *class*(*x*)*.* The classifier can also output a confidence that the input belongs to a class, that is, *f*(*x*) = *confidence*(*class*(*x*))*.* Such classification can employ a probabilistic and/or statistical-based analysis (*e.g*., factoring into the analysis utilities and costs) to prognose or infer an action that a user desires to be automatically performed (e.g., identification of a failure of battery pack 105 based on a pressure event 240.

A support vector machine (SVM) is an example of a classifier that can be employed. The SVM operates by finding a hypersurface in the space of possible inputs that splits the triggering input events from the non-triggering events in an optimal way. Intuitively, this makes the classification correct for testing data that is near, but not identical to training data. Other directed and undirected model classification approaches include, e.g., naive Bayes, Bayesian networks, decision trees, neural networks, fuzzy logic models, and probabilistic classification models providing different patterns of independence can be employed. Classification as used herein is inclusive of statistical regression that is utilized to develop models of priority.

As will be readily appreciated from the subject specification, the various embodiments can employ classifiers that are explicitly trained (e.g., via a generic training data) as well as implicitly trained (e.g., via observing one or more pressure measurements 135A1/136A1/137A1, measurements 135A-n, 136A-n, 137A-*n*, and other measures pertaining to battery pack 105, received extrinsic information, and suchlike). For example, SVM's are configured *via* a learning or training phase within a classifier constructor and feature selection module. Thus, the classifier(s) can be used to automatically learn and perform a number of functions, including but not limited to determining according to predetermined criteria, a pressure event (e.g., pressure event 240) in conjunction with failure of a battery pack 105, for example.

As described *supra,* inferences can be made, and operations performed, based on numerous pieces of information. For example, measurements 135A1, 136A1, 135A-*n*, 136A-*n*, 137A-*n* are compiled with information/data generated by the respective components included in, or in communication with, the battery pack 105 and the information/data accumulates (e.g., in memory 114, measurements database 139) regarding operating conditions of battery pack 105, the respective information can be analyzed to determine converging patterns such that inferences can be made regarding the operational condition of battery pack 105 and probability of failure.

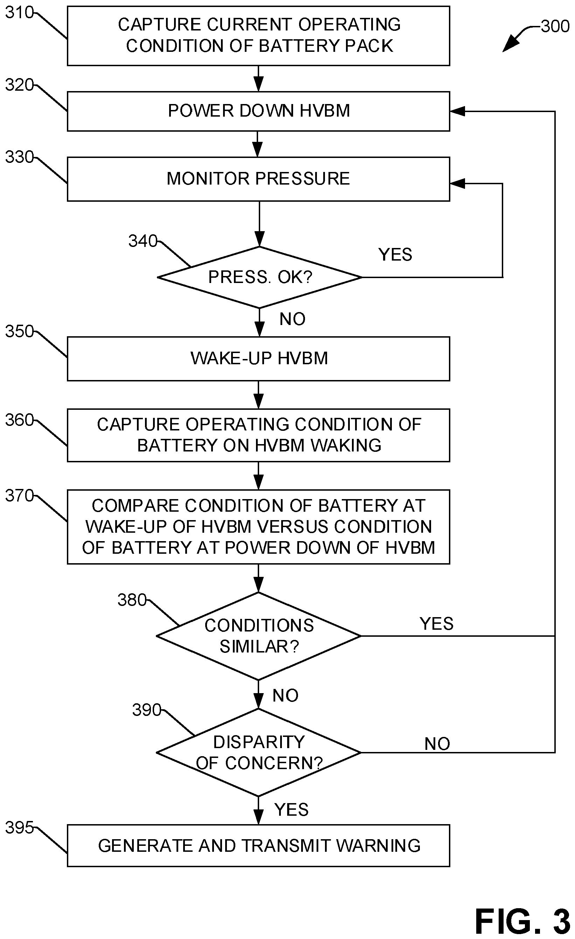

FIG. 3 illustrates a flow diagram 300 for a computer-implemented methodology to detect whether a battery pack is undergoing failure, in accordance with at least one embodiment.

At 310, the current operating conditions (e.g., measurements 135A-*n*) of a battery pack (e.g., battery pack 105) are captured by a HVBM (e.g., by HVBM 127), wherein the conditions can be stored in a database (e.g., measurements database 139). In an embodiment, the current operating conditions can be captured as a vehicle (e.g., vehicle 102) on which the battery pack is operating is parked and turned off (e.g., parked overnight in a garage, on a street, parked at a shopping mall car park, etc.).

At 320, to conserve power available from the battery pack, the HVBM can be turned off as part of powering down the vehicle. However, a battery control ECU (e.g., battery control ECU 122) can remained powered, wherein the battery control ECU can be configured to operate with a fraction of the power required to maintain operation of the HVBM.

At 330, the battery control ECU can include a pressure component (e.g., pressure component 125) configured to monitor operational pressure (e.g., pressure 135A1, 136A1, 137A1) of the battery pack. Per FIGS. 1A and 2A-B, while HVBM is currently inactive, continued monitoring of the battery pack pressure enables an operational baseline (e.g., a pressure baseline 230) to be generated from the continuously received pressure measurements (e.g., from pressure sensor 130A1). In an embodiment, at the moment the HVBM is powered down, the pressure baseline can be created from the pressure measurements (e.g., the last 1 minute, 5 minutes, 10 minutes, and suchlike) stored in the measurements database (e.g., measurements database 139). Post powering down of the HVBM, the pressure baseline can be generated based on the pressure measurements received after the HVBM was powered down. Further, a threshold pressure value (e.g., threshold 126A-n) can be defined (e.g., via an input into the pressure component 125) and applied to the pressure baseline to identify a significant deviation (e.g., pressure event 240) from the pressure baseline. As mentioned in FIGS. 2A-B, the threshold condition/measure can pertain to any suitable measure, such as average, slope, etc.

At 340, a determination can be made (e.g., by the pressure component 125) regarding whether a current pressure event occurring at the battery pack is of concern (e.g., above the threshold). In response to a determination of YES, the current operating pressure is as expected (e.g., below the threshold value), methodology 300 can return to 330 for further monitoring of the current pressure condition.

At 340, in response to a determination that NO, the current operating pressure is not as expected (e.g., equal to, or above, the threshold value 126A-*n*), methodology 300 can advance to 350.

At 350, the pressure component (e.g., via interfaces 121A and 121B) can be configured to generate a notification 166A-*n* to wake up the HVBM.

At 360, the HVBM, once re-initialized, can be configured to a) monitor all of the respective variables/parameters 137A-*n*, b) obtain signals from all of the sensors 130A-*n*, c) obtain operational data from other systems (e.g., from components/devices operating in other systems 160 on board vehicle 102), and suchlike.

At 370, the HVBM can further compare the respective measurements stored in the measurements database (e.g., measurements 136A-*n* in measurements database 139) prior to powering down the HVBM with the measurements (e.g., measurements 137A-*n*) obtained by the HVBM after wake-up of the HVBM. The comparison by the HVBM can include a) comparing all of the respective variables/parameters from both before shut down of the HVBM and after waking up the HVBM, b) review operation of all of the sensors 130A-*n*, c) conduct fault analysis 151A-*n* to isolate other causes (e.g., in components and devices in other systems 160) that may have given rise to change in pressure event, d) and suchlike to identify whether the pressure event is i) an actual pressure-based event and not the result of some unrelated event elsewhere on the vehicle, ii) to the other variables/parameters indicate that the battery pack is undergoing failure?

At 380, in response to a determination (e.g., analysis 151A-*n*) by the HVBM that the respective variables, sensors, other systems (e.g., 136A-*n*/137A-*n*, sensors 130A-*n*, other systems 160, etc.) all have an expected magnitude or are operating as expected, the battery pack can be considered to be operating as expected and methodology 300 can return to 320, whereupon the HVBM can be powered down, and further monitoring of the pressure values (e.g., pressure values) 135A/136A/137A can be conducted (e.g., by the pressure component 125). As part of the review, any identified sensor defects (e.g., in sensors 130A-*n*) can be addressed (e.g., sensors are to be replaced), spurious signals arising from other causes (e.g., other systems 160) can be isolated and further analysis conducted to mitigate future effects of the spurious signals, and suchlike.

At 380, in response to a determination that magnitude or operation of the respective variables, sensors, other systems, etc., are not as expected, methodology 300 can advance to 390, wherein further review can be conducted to determine whether the battery pack is failing. In response to a determination (e.g., by the HVBM 127) that while disparities between the operating conditions prior to/at shut down of the HVBM and after restart of the HVBM may exist, the battery pack is not failing, methodology 300 can return to 320, whereupon the HVBM can be powered down, and further monitoring of the pressure values (e.g., pressure values 135A1/136A1/137A1) can be conducted (e.g., by the pressure component 125).

At 390, in response to a determination (e.g., by HVBM 127) that the disparities between the operating conditions prior to/at shut down of the HVBM and after restart of the HVBM indicate that the battery pack is undergoing failure/failed), the HVBM can generate and transmit an instruction (e.g., in a notification 166A-n) to a warning component (e.g., warning component 170) that the battery pack may be failing and appropriate action should be taken. As previously described, the warning component can generate and transmit warnings/alerts (e.g., in notifications 166A-*n*) to external devices and systems for appropriate action to be taken, e.g., leave building, emergency services to address, etc. Further, as previously mentioned, the warning component can further generate and transmit a warning to the vehicle's navigation system to autonomously relocate the vehicle.

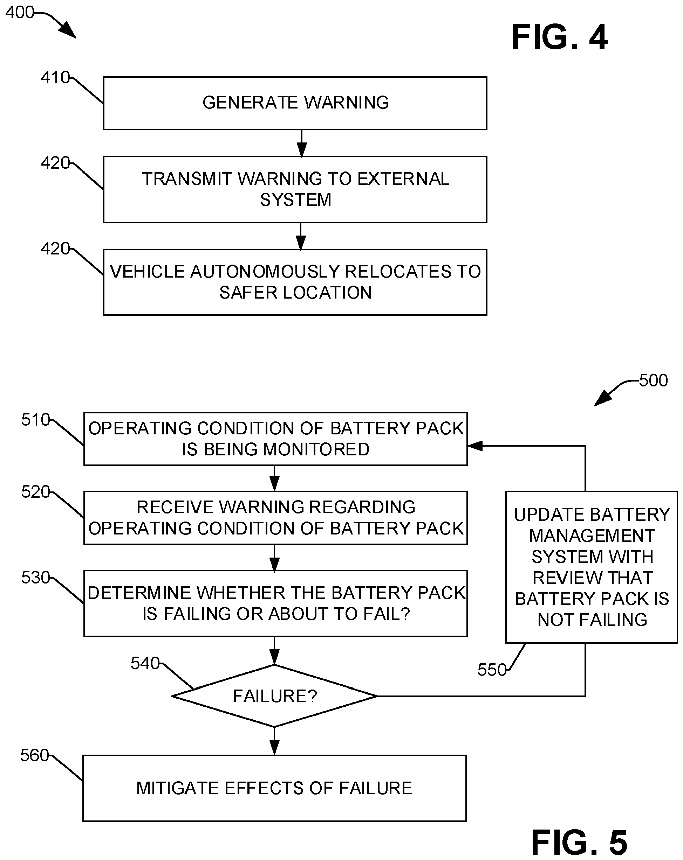

FIG. 4 illustrates a flow diagram 400 for a computer-implemented methodology to distribute a battery pack failure warning to various devices and systems, in accordance with at least one embodiment.

At 410, in response to a determination (e.g., by HVBM 127 located onboard vehicle 105) that a battery pack (e.g., battery pack 105) is potentially undergoing a failure (e.g., a thermal failure), a warning component (e.g., warning component 170) can receive an instruction to generate and transmit one or more warnings/alarms (e.g., notifications 166A-*n*).

At 420, the warning component can be configured to transmit a warning (e.g., a notification 166A-*n*) to an external system (e.g., system 199) or device (e.g., device 192A-*n*). As previously described, the external system can be operated by any of a manufacturer of the battery pack, a manufacturer of the vehicle on which the battery pack is located, an emergency service(s), and suchlike.

At 430, in another embodiment, the warning component can be configured to generate and transmit a warning/alert to a navigation system (e.g., navigation system 169) located onboard the vehicle. In response to receiving the warning, the navigation component can be preconfigured with a location at which to relocate the vehicle to, e.g., to minimize the possibility of a fire at the battery pack extending to a surrounding building, etc. Accordingly, the navigation component can autonomously relocate the vehicle. In another embodiment, the navigation component can be configured with parameters regarding what constitutes a safe location for the vehicle to be parked while the battery failure occurs, the navigation component can review proximate locations (e.g., based on GPS data, maps, instructions received from an external system/device - e.g., generated by an emergency service) and autonomously relocate the vehicle to a suitable proximate location.

FIG. 5 illustrates a flow diagram 500 for a computer-implemented methodology of viable responses to an indication of a battery pack is potentially failing, in accordance with at least one embodiment.

At 510, the operating condition of a battery pack (e.g., battery pack 105) located on a vehicle (e.g., vehicle 102) is being monitored. While the vehicle is powered down (e.g., parked) monitoring of the battery pack can be based on monitoring by a pressure component (e.g., by a pressure component 125 in a battery control ECU 122) the pressure (e.g., pressure 135A1/136A1/137A1) at the battery pack via a pressure sensor (e.g., pressure sensor 130A1). In the event of the pressure exceeds a threshold (e.g., a threshold 126A-*n* versus a baseline value regarding magnitude, slope, percentage, and suchlike), the pressure component can be configured to wake a HVBM (e.g., HVBM 127) to determine whether the battery pack is failing. Failure analysis by the HVBM can be based on comparing current operating conditions of the battery pack versus operating conditions present when the HVBM was powered down (e.g., as part of the vehicle being powered down). In response to a determination by the HVBM that the battery pack is failing, the HVBM can be further configured to instruct a warning component (e.g., warning component 170) to generate and transmit a warning (e.g., in notifications 166A-*n*) that the battery pack appears to be failing/is failing.

At 520, a user device (e.g., device 192A-*n*) or an external system (e.g., external system 199) can receive and present the warning.

At 530, an input into either the user device or the external system can be received regarding a determination as to whether the battery pack is failing. In an embodiment, the determination can be made by the owner of the vehicle, an emergency services employee, an engineer employed by the manufacturer of the battery pack or the manufacturer of the vehicle, and suchlike).

At 540, in response to an input indicating a determination that NO, the battery pack is not failing, methodology 500 can advance to 550 whereby either the pressure component or the HVBM can be reconfigured/updated with the characteristics of the determination to further train the pressure component or the HVBM (e.g., the processes 129A-*n*). Methodology 500 can further return to 510, whereby the HVBM can be powered down once more and further monitoring to be performed by the pressure component.

At 540, in response to a determination of the battery pack appears to be or is failing, methodology 500 can advance to 560 whereby the effects of the failure can be mitigated, e.g., evacuate a building where the vehicle is parked, extinguish the fire, autonomously relocate the vehicle, and suchlike.

### EXAMPLE OPERATING ENVIRONMENT AND SCENARIOS

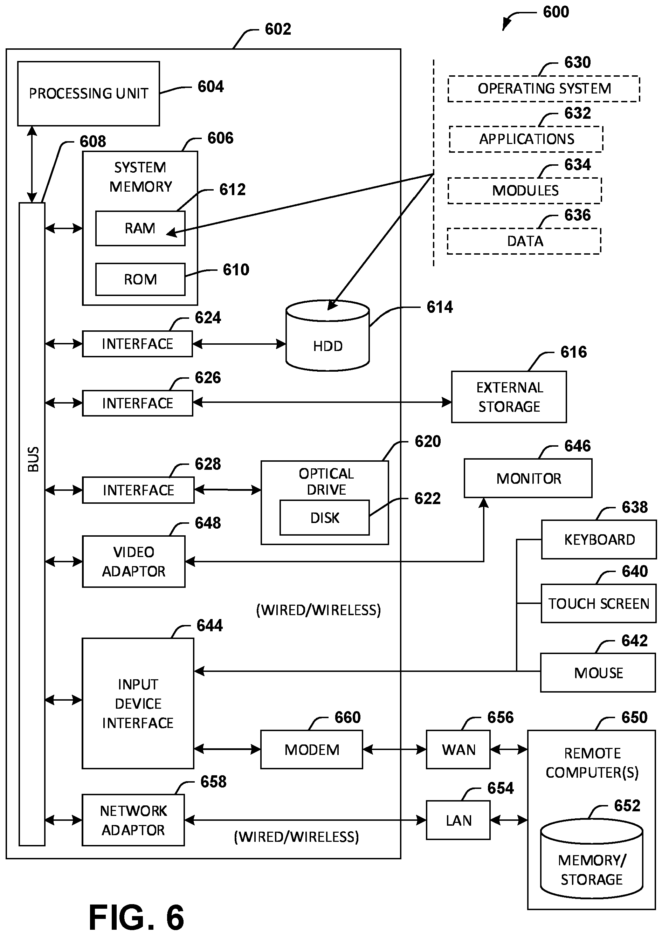

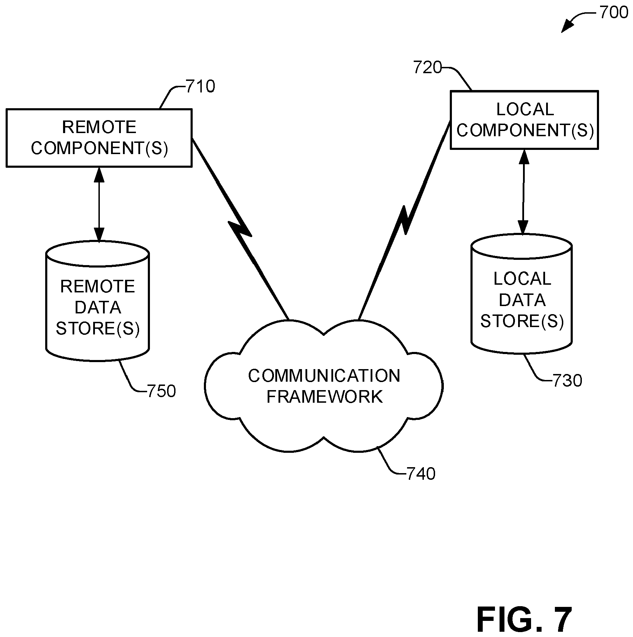

Turning next to FIGS. 6 and 7, a detailed description is provided of additional context for the one or more embodiments described herein with FIGS. 1A-5.

In order to provide additional context for various embodiments described herein, FIG. 6 and the following discussion are intended to provide a brief, general description of a suitable computing environment 600 in which the various embodiments described herein can be implemented. While the embodiments have been described above in the general context of computer-executable instructions that can run on one or more computers, those skilled in the art will recognize that the embodiments can be also implemented in combination with other program modules and/or as a combination of hardware and software.

Generally, program modules include routines, programs, components, data structures, etc., that perform particular tasks or implement particular abstract data types. Moreover, those skilled in the art will appreciate that the methods can be practiced with other computer system configurations, including single-processor or multiprocessor computer systems, minicomputers, mainframe computers, IoT devices, distributed computing systems, as well as personal computers, hand-held computing devices, microprocessor-based or programmable consumer electronics, and the like, each of which can be operatively coupled to one or more associated devices.

The embodiments illustrated herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, and/or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD-ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible and/or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infra-red and other wireless media.

With reference again to FIG. 6, the example environment 600 for implementing various embodiments of the aspects described herein includes a computer 602, the computer 602 including a processing unit 604, a system memory 606 and a system bus 608. The system bus 608 couples system components including, but not limited to, the system memory 606 to the processing unit 604. The processing unit 604 can be any of various commercially available processors and may include a cache memory. Dual microprocessors and other multi-processor architectures can also be employed as the processing unit 604.

The system bus 608 can be any of several types of bus structure that can further interconnect to a memory bus (with or without a memory controller), a peripheral bus, and a local bus using any of a variety of commercially available bus architectures. The system memory 606 includes ROM 610 and RAM 612. A basic input/output system (BIOS) can be stored in a non-volatile memory such as ROM, erasable programmable read only memory (EPROM), EEPROM, which BIOS contains the basic routines that help to transfer information between elements within the computer 602, such as during startup. The RAM 612 can also include a high-speed RAM such as static RAM for caching data.

The computer 602 further includes an internal hard disk drive (HDD) 614 (e.g., EIDE, SATA), one or more external storage devices 616 (e.g., a magnetic floppy disk drive (FDD) 616, a memory stick or flash drive reader, a memory card reader, etc.) and an optical disk drive 620 (e.g., which can read or write from a CD-ROM disc, a DVD, a BD, etc.). While the internal HDD 614 is illustrated as located within the computer 602, the internal HDD 614 can also be configured for external use in a suitable chassis (not shown). Additionally, while not shown in environment 600, a solid-state drive (SSD) could be used in addition to, or in place of, an HDD 614. The HDD 614, external storage device(s) 616 and optical disk drive 620 can be connected to the system bus 608 by an HDD interface 624, an external storage interface 626 and an optical drive interface 628, respectively. The interface 624 for external drive implementations can include at least one or both of Universal Serial Bus (USB) and Institute of Electrical and Electronics Engineers (IEEE) 1094 interface technologies. Other external drive connection technologies are within contemplation of the embodiments described herein.

The drives and their associated computer-readable storage media provide nonvolatile storage of data, data structures, computer-executable instructions, and so forth. For the computer 602, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 612, including an operating system 630, one or more application programs 632, other program modules 634 and program data 636. All or portions of the operating system, applications, modules, and/or data can also be cached in the RAM 612. The systems and methods described herein can be implemented utilizing various commercially available operating systems or combinations of operating systems.

Computer 602 can optionally comprise emulation technologies. For example, a hypervisor (not shown) or other intermediary can emulate a hardware environment for operating system 630, and the emulated hardware can optionally be different from the hardware illustrated in FIG. 6. In such an embodiment, operating system 630 can comprise one virtual machine (VM) of multiple VMs hosted at computer 602. Furthermore, operating system 630 can provide runtime environments, such as the Java runtime environment or the .NET framework, for applications 632. Runtime environments are consistent execution environments that allow applications 632 to run on any operating system that includes the runtime environment. Similarly, operating system 630 can support containers, and applications 632 can be in the form of containers, which are lightweight, standalone, executable packages of software that include, e.g., code, runtime, system tools, system libraries and settings for an application.

Further, computer 602 can comprise a security module, such as a trusted processing module (TPM). For instance with a TPM, boot components hash next in time boot components, and wait for a match of results to secured values, before loading a next boot component. This process can take place at any layer in the code execution stack of computer 602, e.g., applied at the application execution level or at the operating system (OS) kernel level, thereby enabling security at any level of code execution.

A user can enter commands and information into the computer 602 through one or more wired/wireless input devices, e.g., a keyboard 638, a touch screen 640, and a pointing device, such as a mouse 642. Other input devices (not shown) can include a microphone, an infra-red (IR) remote control, a radio frequency (RF) remote control, or other remote control, a joystick, a virtual reality controller and/or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 604 through an input device interface 644 that can be coupled to the system bus 608, but can be connected by other interfaces, such as a parallel port, an IEEE 1094 serial port, a game port, a USB port, an IR interface, a BLUETOOTH^{®} interface, etc.

A monitor 646 or other type of display device can be also connected to the system bus 608 via an interface, such as a video adapter 648. In addition to the monitor 646, a computer typically includes other peripheral output devices (not shown), such as speakers, printers, etc.

The computer 602 can operate in a networked environment using logical connections via wired and/or wireless communications to one or more remote computers, such as a remote computer(s) 650. The remote computer(s) 650 can be a workstation, a server computer, a router, a personal computer, portable computer, microprocessor-based entertainment appliance, a peer device or other common network node, and typically includes many or all of the elements described relative to the computer 602, although, for purposes of brevity, only a memory/storage device 652 is illustrated. The logical connections depicted include wired/wireless connectivity to a local area network (LAN) 654 and/or larger networks, e.g., a wide area network (WAN) 656. Such LAN and WAN networking environments are commonplace in offices and companies, and facilitate enterprise-wide computer networks, such as intranets, all of which can connect to a global communications network, e.g., the internet.

When used in a LAN networking environment, the computer 602 can be connected to the local network 654 through a wired and/or wireless communication network interface or adapter 658. The adapter 658 can facilitate wired or wireless communication to the LAN 654, which can also include a wireless access point (AP) disposed thereon for communicating with the adapter 658 in a wireless mode.

When used in a WAN networking environment, the computer 602 can include a modem 660 or can be connected to a communications server on the WAN 656 via other means for establishing communications over the WAN 656, such as by way of the internet. The modem 660, which can be internal or external and a wired or wireless device, can be connected to the system bus 608 via the input device interface 644. In a networked environment, program modules depicted relative to the computer 602 or portions thereof, can be stored in the remote memory/storage device 652. It will be appreciated that the network connections shown are example and other means of establishing a communications link between the computers can be used.

When used in either a LAN or WAN networking environment, the computer 602 can access cloud storage systems or other network-based storage systems in addition to, or in place of, external storage devices 616 as described above. Generally, a connection between the computer 602 and a cloud storage system can be established over a LAN 654 or WAN 656 e.g., by the adapter 658 or modem 660, respectively. Upon connecting the computer 602 to an associated cloud storage system, the external storage interface 626 can, with the aid of the adapter 658 and/or modem 660, manage storage provided by the cloud storage system as it would other types of external storage. For instance, the external storage interface 626 can be configured to provide access to cloud storage sources as if those sources were physically connected to the computer 602.

The computer 602 can be operable to communicate with any wireless devices or entities operatively disposed in wireless communication, e.g., a printer, scanner, desktop and/or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a predefined structure as with a conventional network or simply an ad hoc communication between at least two devices.

The above description includes non-limiting examples of the various embodiments. It is, of course, not possible to describe every conceivable combination of components or methodologies for purposes of describing the disclosed subject matter, and one skilled in the art may recognize that further combinations and permutations of the various embodiments are possible. The disclosed subject matter is intended to embrace all such alterations, modifications, and variations that fall within the spirit and scope of the appended claims.

Referring now to details of one or more elements illustrated at FIG. 7, an illustrative cloud computing environment 700 is depicted. FIG. 7 is a schematic block diagram of a computing environment 700 with which the disclosed subject matter can interact. The system 700 comprises one or more remote component(s) 710. The remote component(s) 710 can be hardware and/or software (e.g., threads, processes, computing devices). In some embodiments, remote component(s) 710 can be a distributed computer system, connected to a local automatic scaling component and/or programs that use the resources of a distributed computer system, via communication framework 740. Communication framework 740 can comprise wired network devices, wireless network devices, mobile devices, wearable devices, radio access network devices, gateway devices, femtocell devices, servers, etc.

The system 700 also comprises one or more local component(s) 720. The local component(s) 720 can be hardware and/or software (e.g., threads, processes, computing devices). In some embodiments, local component(s) 720 can comprise an automatic scaling component and/or programs that communicate / use the remote resources 710 and 720, etc., connected to a remotely located distributed computing system via communication framework 740.

One possible communication between a remote component(s) 710 and a local component(s) 720 can be in the form of a data packet adapted to be transmitted between two or more computer processes. Another possible communication between a remote component(s) 710 and a local component(s) 720 can be in the form of circuit-switched data adapted to be transmitted between two or more computer processes in radio time slots. The system 700 comprises a communication framework 740 that can be employed to facilitate communications between the remote component(s) 710 and the local component(s) 720, and can comprise an air interface, e.g., Uu interface of a UMTS network, via a long-term evolution (LTE) network, etc. Remote component(s) 710 can be operably connected to one or more remote data store(s) 750, such as a hard drive, solid state drive, SIM card, device memory, etc., that can be employed to store information on the remote component(s) 710 side of communication framework 740. Similarly, local component(s) 720 can be operably connected to one or more local data store(s) 730, that can be employed to store information on the local component(s) 720 side of communication framework 740.

With regard to the various functions performed by the above described components, devices, circuits, systems, etc., the terms (including a reference to a "means") used to describe such components are intended to also include, unless otherwise indicated, any structure(s) which performs the specified function of the described component (e.g., a functional equivalent), even if not structurally equivalent to the disclosed structure. In addition, while a particular feature of the disclosed subject matter may have been disclosed with respect to only one of several implementations, such feature may be combined with one or more other features of the other implementations as may be desired and advantageous for any given or particular application.

The terms "exemplary" and/or "demonstrative" as used herein are intended to mean serving as an example, instance, or illustration. For the avoidance of doubt, the subject matter disclosed herein is not limited by such examples. In addition, any aspect or design described herein as "exemplary" and/or "demonstrative" is not necessarily to be construed as preferred or advantageous over other aspects or designs, nor is it meant to preclude equivalent structures and techniques known to one skilled in the art. Furthermore, to the extent that the terms "includes," "has," "contains," and other similar words are used in either the detailed description or the claims, such terms are intended to be inclusive - in a manner similar to the term "comprising" as an open transition word - without precluding any additional or other elements.

The term "or" as used herein is intended to mean an inclusive "or" rather than an exclusive "or." For example, the phrase "A or B" is intended to include instances of A, B, and both A and B. Additionally, the articles "a" and "an" as used in this application and the appended claims should generally be construed to mean "one or more" unless either otherwise specified or clear from the context to be directed to a singular form.

The term "set" as employed herein excludes the empty set, i.e., the set with no elements therein. Thus, a "set" in the subject disclosure includes one or more elements or entities. Likewise, the term "group" as utilized herein refers to a collection of one or more entities.

The terms "first," "second," "third," and so forth, as used in the claims, unless otherwise clear by context, is for clarity only and doesn't otherwise indicate or imply any order in time. For instance, "a first determination," "a second determination," and "a third determination," does not indicate or imply that the first determination is to be made before the second determination, or vice versa, etc.

As used in this disclosure, in some embodiments, the terms "component," "system" and the like are intended to refer to, or comprise, a computer-related entity or an entity related to an operational apparatus with one or more specific functionalities, wherein the entity can be either hardware, a combination of hardware and software, software, or software in execution. As an example, a component can be, but is not limited to being, a process running on a processor, a processor, an object, an executable, a thread of execution, computer-executable instructions, a program, and/or a computer. By way of illustration and not limitation, both an application running on a server and the server can be a component.

One or more components can reside within a process and/or thread of execution and a component can be localized on one computer and/or distributed between two or more computers. In addition, these components can execute from various computer readable media having various data structures stored thereon. The components can communicate via local and/or remote processes such as in accordance with a signal having one or more data packets (e.g., data from one component interacting with another component in a local system, distributed system, and/or across a network such as the internet with other systems via the signal). As another example, a component can be an apparatus with specific functionality provided by mechanical parts operated by electric or electronic circuitry, which is operated by a software application or firmware application executed by a processor, wherein the processor can be internal or external to the apparatus and executes at least a part of the software or firmware application. As yet another example, a component can be an apparatus that provides specific functionality through electronic components without mechanical parts, the electronic components can comprise a processor therein to execute software or firmware that confers at least in part the functionality of the electronic components. While various components have been illustrated as separate components, it will be appreciated that multiple components can be implemented as a single component, or a single component can be implemented as multiple components, without departing from example embodiments.

The term "facilitate" as used herein is in the context of a system, device or component "facilitating" one or more actions or operations, in respect of the nature of complex computing environments in which multiple components and/or multiple devices can be involved in some computing operations. Non-limiting examples of actions that may or may not involve multiple components and/or multiple devices comprise transmitting or receiving data, establishing a connection between devices, determining intermediate results toward obtaining a result, etc. In this regard, a computing device or component can facilitate an operation by playing any part in accomplishing the operation. When operations of a component are described herein, it is thus to be understood that where the operations are described as facilitated by the component, the operations can be optionally completed with the cooperation of one or more other computing devices or components, such as, but not limited to, sensors, antennae, audio and/or visual output devices, other devices, etc.

Further, the various embodiments can be implemented as a method, apparatus or article of manufacture using standard programming and/or engineering techniques to produce software, firmware, hardware, or any combination thereof to control a computer to implement the disclosed subject matter. The term "article of manufacture" as used herein is intended to encompass a computer program accessible from any computer-readable (or machine-readable) device or computer-readable (or machine-readable) storage/communications media. For example, computer readable storage media can comprise, but are not limited to, magnetic storage devices (e.g., hard disk, floppy disk, magnetic strips), optical disks (e.g., compact disk (CD), digital versatile disk (DVD)), smart cards, and flash memory devices (e.g., card, stick, key drive). Of course, those skilled in the art will recognize many modifications can be made to this configuration without departing from the scope or spirit of the various embodiments.

Moreover, terms such as "mobile device equipment," "mobile station," "mobile," "subscriber station," "access terminal," "terminal," "handset," "communication device," "mobile device" (and/or terms representing similar terminology) can refer to a wireless device utilized by a subscriber or mobile device of a wireless communication service to receive or convey data, control, voice, video, sound, gaming or substantially any data-stream or signaling-stream. The foregoing terms are utilized interchangeably herein and with reference to the related drawings. Likewise, the terms "access point (AP)," "Base Station (BS)," "BS transceiver," "BS device," "cell site," "cell site device," "gNode B (gNB)," "evolved Node B (eNode B, eNB)," "home Node B (HNB)" and the like, refer to wireless network components or appliances that transmit and/or receive data, control, voice, video, sound, gaming or substantially any data-stream or signaling-stream from one or more subscriber stations. Data and signaling streams can be packetized or frame-based flows.

Furthermore, the terms "device," "communication device," "mobile device," "subscriber," "client entity," "consumer," "client entity," "entity" and the like are employed interchangeably throughout, unless context warrants particular distinctions among the terms. It should be appreciated that such terms can refer to human entities or automated components supported through artificial intelligence (e.g., a capacity to make inference based on complex mathematical formalisms), which can provide simulated vision, sound recognition and so forth.

It should be noted that although various aspects and embodiments are described herein in the context of 5G or other next generation networks, the disclosed aspects are not limited to a 5G implementation, and can be applied in other network next generation implementations, such as sixth generation (6G), or other wireless systems. In this regard, aspects or features of the disclosed embodiments can be exploited in substantially any wireless communication technology. Such wireless communication technologies can include universal mobile telecommunications system (UMTS), global system for mobile communication (GSM), code division multiple access (CDMA), wideband CDMA (WCMDA), CDMA2000, time division multiple access (TDMA), frequency division multiple access (FDMA), multi-carrier CDMA (MC-CDMA), single-carrier CDMA (SC-CDMA), single-carrier FDMA (SC-FDMA), orthogonal frequency division multiplexing (OFDM), discrete Fourier transform spread OFDM (DFT-spread OFDM), filter bank based multi-carrier (FBMC), zero tail DFT-spread-OFDM (ZT DFT-s-OFDM), generalized frequency division multiplexing (GFDM), fixed mobile convergence (FMC), universal fixed mobile convergence (UFMC), unique word OFDM (UW-OFDM), unique word DFT-spread OFDM (UW DFT-Spread-OFDM), cyclic prefix OFDM (CP-OFDM), resource-block-filtered OFDM, wireless fidelity (Wi-Fi), worldwide interoperability for microwave access (WiMAX), wireless local area network (WLAN), general packet radio service (GPRS), enhanced GPRS, third generation partnership project (3GPP), long term evolution (LTE), 5G, third generation partnership project 2 (3GPP2), ultra-mobile broadband (UMB), high speed packet access (HSPA), evolved high speed packet access (HSPA+), high-speed downlink packet access (HSDPA), high-speed uplink packet access (HSUPA), Zigbee, or another institute of electrical and electronics engineers (IEEE) 802.12 technology.

The description of illustrated embodiments of the subject disclosure as provided herein, including what is described in the Abstract, is not intended to be exhaustive or to limit the disclosed embodiments to the precise forms disclosed. While specific embodiments and examples are described herein for illustrative purposes, various modifications are possible that are considered within the scope of such embodiments and examples, as one skilled in the art can recognize. In this regard, while the subject matter has been described herein in connection with various embodiments and corresponding drawings, where applicable, it is to be understood that other similar embodiments can be used or modifications and additions can be made to the described embodiments for performing the same, similar, alternative, or substitute function of the disclosed subject matter without deviating therefrom. Therefore, the disclosed subject matter should not be limited to any single embodiment described herein, but rather should be construed in breadth and scope in accordance with the appended claims below.

Various non-limiting aspects of various embodiments described herein are presented in the following clauses.

Clause 1: A system, located on a vehicle, comprising: a memory that stores computer executable components; and a processor that executes the computer executable components stored in the memory, wherein the computer executable components comprise: a sensor component configured to: monitor an operating pressure of a battery located on the vehicle, wherein the vehicle is in a powered off mode of operation and high voltage battery module (HVBM) is powered down, detect occurrence of an event at the battery, and in response to detection of the event at the battery, reinitiate operation of a high voltage battery module (HVBM).

Clause 2: The system of any preceding clause, wherein the sensor component is a pressure component configured to determine pressure, and the event is a change in pressure at the battery.

Clause 3: The system of any preceding clause, wherein the sensor component is further configured to: determine a difference between a current pressure value measured at the battery measured by a pressure sensor and a baseline pressure value previously measured by the pressure sensor; and in response to the difference being greater than a threshold, identifying the event has occurred.

Clause 4: The system of any preceding clause, wherein the HVBM is further configured to: analyze signals from one or more systems onboard the vehicle to identify a source of signal interference generated at the one or more systems, wherein the signal interference causing the difference between the current pressure value measured by the pressure sensor and the baseline pressure value measured by the pressure sensor.

Clause 5: The system of any preceding clause, wherein the one or more systems comprise a motor system, a climate control system, a velocity system, or a navigation system.

Clause 6: The system of any preceding clause, wherein the HVBM is further configured to: identify a first number of sensor signals present in the first set of measurements, identify a second number of sensor signals present in the second set of measurements, determine whether the first number of sensor signals equals the second number of sensor signals, and in response to a determination of the first number of sensor signals does not equal the second number of sensor signals, identify a failed sensor.

Clause 7: The system of any preceding clause, wherein the HVBM is configured to: prior to being powered down, capture a first set of measurements regarding operating condition of the battery at the time the HVBM was powered down, upon operation of the HVBM being reinitiated by the sensor component, capture a second set of measurements regarding a current operating condition of the battery , compare the first set of measurements with the second set of measurements, and in response to a discrepancy between the first set of measurements with the second set of measurements, generate and transmit a failure notification that the battery is in a condition of potential failure.

Clause 8: The system of any preceding clause, wherein the battery is a lithium-ion battery, and the HVBM is further configured to determine, based on the comparison between the first set of measurements and the second set of measurements, whether the event was an off-gassing event at the battery.

Clause 9: The system of any preceding clause, further comprising a warning component, configured to: receive the failure notification, generate a warning notification indicating the battery is in a potential failure condition, and transmit the warning notification to a remotely located user device, wherein the warning notification includes an instruction to evacuate a building in which the vehicle is located.

Clause 10: The system of any preceding clause, wherein the warning component is further configured to transmit the warning notification to a navigation component onboard the vehicle, wherein the warning notification includes an instruction for the navigation component to autonomously drive the vehicle to a designated safe location.

Clause 11: A computer-implemented method comprising: monitoring, by a device comprising a processor located on a vehicle, a current pressure condition at a battery pack, wherein the current pressure condition is monitored while a high voltage battery module (HVBM) is powered down, wherein the HVBM is configured to control operation of the battery pack, comparing, by the device, the current pressure condition with a baseline condition to identify existence of a pressure event at the battery pack, and in response to identifying the existence of the pressure event, activating, by the device, operation of the HVBM configured to determine whether the pressure event is indicative of the battery pack is failing.

Clause 12: The computer-implemented method of any preceding clause, further comprising: during power down of the HVBM, obtaining by the HVBM, a set of operating conditions of the battery pack, during activation of the HVBM, obtaining by the HVBM, a set of current operating conditions of the battery pack, comparing, by the HVBM, the set of current operating conditions with the set of power down operating conditions, determining, by the HVBM, a variation in the current operating conditions versus the power down operating conditions, and in the event of the variation is indicative of the current condition of the battery pack is failing, generating an alarm indicating the battery pack is failing.

Clause 13: The computer-implemented method of any preceding clause, wherein the battery pack comprises at least one lithium-ion battery cell.

Clause 14: The computer-implemented method of any preceding clause, wherein the pressure event is due to off-gassing at the battery pack.

Clause 15: The computer-implemented method of any preceding clause, wherein the pressure event is due to at least one of physical failure or chemical failure of at least one cell in the battery pack.

Clause 16: A computer program product for determining failure of a battery pack located on a vehicle, the computer program product comprising a computer readable storage medium having program instructions embodied therewith, the program instructions executable by a processor to cause the processor to: monitor a current pressure condition at a battery pack, wherein the current pressure condition is monitored while a high voltage battery module (HVBM) is powered down, wherein the HVBM is configured to control operation of the battery pack, compare the current pressure condition with a baseline pressure condition to identify existence of a pressure event at the battery pack, and in response to identifying the existence of the pressure event, activating operation of the HVBM configured to determine whether the pressure event is indicative of the battery pack is failing.

Clause 17: The computer program product of any preceding clause, wherein the program instructions are further executable by the processor to cause the processor to during power down of the HVBM, obtain a set of operating conditions of the battery pack, during activation of the HVBM, obtain a set of current operating conditions of the battery pack, compare the set of current operating conditions with the set of power down operating conditions, determine a variation in the current operating conditions versus the power down operating conditions, and in the event of the variation is indicative of the current condition of the battery pack is failing, generate an alarm indicating the battery pack is failing.

Clause 18: The computer program product of any preceding clause, wherein the battery pack comprises at least one lithium-ion battery cell.

Clause 19: The computer program product of any preceding clause, wherein the pressure event is due to off-gassing at the battery pack.

Clause 20: The computer program product of any preceding clause, wherein the pressure event is due to at least one of physical failure or chemical failure of at least one cell in the battery pack

In various cases, any suitable combination of clauses 1-10 can be implemented.

In various cases, any suitable combination of clauses 11-15 can be implemented.

In various cases, any suitable combination of clauses 16-20 can be implemented.

## Claims

1. A system, located on a vehicle, comprising:
a memory that stores computer executable components; and
a processor that executes the computer executable components stored in the memory, wherein the computer executable components comprise:
a sensor component configured to:
monitor an operating pressure of a battery located on the vehicle, wherein the vehicle is in a powered off mode of operation and high voltage battery module (HVBM) is powered down;
detect occurrence of an event at the battery; and
in response to detection of the event at the battery, reinitiate operation of a high voltage battery module (HVBM).

2. The system of claim 1, wherein the sensor component is a pressure component configured to determine pressure, and the event is a change in pressure at the battery.

3. The system of claim 2, wherein the sensor component is further configured to:
determine a difference between a current pressure value measured at the battery measured by a pressure sensor and a baseline pressure value previously measured by the pressure sensor; and
in response to the difference being greater than a threshold, identifying the event has occurred.

4. The system of claim 3, wherein the HVBM is further configured to:
analyze signals from one or more systems onboard the vehicle to identify a source of signal interference generated at the one or more systems, wherein the signal interference causing the difference between the current pressure value measured by the pressure sensor and the baseline pressure value measured by the pressure sensor.

5. The system of claim 4, wherein the one or more systems comprise a motor system, a climate control system, a velocity system, or a navigation system.

6. The system of claim 3, wherein the HVBM is further configured to:
identify a first number of sensor signals present in the first set of measurements;
identify a second number of sensor signals present in the second set of measurements;
determine whether the first number of sensor signals equals the second number of sensor signals; and
in response to a determination of the first number of sensor signals does not equal the second number of sensor signals, identify a failed sensor.

7. The system of claim 1, wherein the HVBM is configured to:
prior to being powered down, capture a first set of measurements regarding operating condition of the battery at the time the HVBM was powered down;
upon operation of the HVBM being reinitiated by the sensor component, capture a second set of measurements regarding a current operating condition of the battery;
compare the first set of measurements with the second set of measurements; and
in response to a discrepancy between the first set of measurements with the second set of measurements, generate and transmit a failure notification that the battery is in a condition of potential failure.

8. The system of claim 7, wherein the battery is a lithium-ion battery, and the HVBM is further configured to determine, based on the comparison between the first set of measurements and the second set of measurements, whether the event was an off-gassing event at the battery.

9. The system of claim 7, further comprising a warning component, configured to:
receive the failure notification;
generate a warning notification indicating the battery is in a potential failure condition; and
transmit the warning notification to a remotely located user device, wherein the warning notification includes an instruction to evacuate a building in which the vehicle is located.

10. The system of claim 9, wherein the warning component is further configured to transmit the warning notification to a navigation component onboard the vehicle, wherein the warning notification includes an instruction for the navigation component to autonomously drive the vehicle to a designated safe location.

11. A computer-implemented method comprising:
monitoring, by a device comprising a processor located on a vehicle, a current pressure condition at a battery pack, wherein the current pressure condition is monitored while a high voltage battery module (HVBM) is powered down, wherein the HVBM is configured to control operation of the battery pack;
comparing, by the device, the current pressure condition with a baseline condition to identify existence of a pressure event at the battery pack; and
in response to identifying the existence of the pressure event, activating, by the device, operation of the HVBM configured to determine whether the pressure event is indicative of the battery pack is failing.

12. The computer-implemented method of claim 11, further comprising:
during power down of the HVBM, obtaining by the HVBM, a set of operating conditions of the battery pack;
during activation of the HVBM, obtaining by the HVBM, a set of current operating conditions of the battery pack;
comparing, by the HVBM, the set of current operating conditions with the set of power down operating conditions;
determining, by the HVBM, a variation in the current operating conditions versus the power down operating conditions; and
in the event of the variation is indicative of the current condition of the battery pack is failing, generating an alarm indicating the battery pack is failing.

13. The computer-implemented method of claim 11, wherein the pressure event is due to at least one of physical failure or chemical failure of at least one cell in the battery pack.

14. A computer program product for determining failure of a battery pack located on a vehicle, the computer program product comprising a computer readable storage medium having program instructions embodied therewith, the program instructions executable by a processor to cause the processor to:
monitor a current pressure condition at a battery pack, wherein the current pressure condition is monitored while a high voltage battery module (HVBM) is powered down, wherein the HVBM is configured to control operation of the battery pack;
compare the current pressure condition with a baseline pressure condition to identify existence of a pressure event at the battery pack; and
in response to identifying the existence of the pressure event, activating operation of the HVBM configured to determine whether the pressure event is indicative of the battery pack is failing.

15. The computer program product of claim 14, wherein the program instructions are further executable by the processor to cause the processor to
during power down of the HVBM, obtain a set of operating conditions of the battery pack;
during activation of the HVBM, obtain a set of current operating conditions of the battery pack;
compare the set of current operating conditions with the set of power down operating conditions;
determine a variation in the current operating conditions versus the power down operating conditions; and
in the event of the variation is indicative of the current condition of the battery pack is failing, generate an alarm indicating the battery pack is failing.
